# EUROPEAN PATENT APPLICATION

(11) **EP 4 679 427 A2**
(43) Date of publication of application: **14.01.2026**
(21) Application number: 25180503.2
(22) Date of filing: 03.06.2025
(51) Int. Cl.: G11C 7/06, G11C 7/08, G11C 16/04, G11C 16/26, G11C 11/56

(54) **MEMORY DEVICE**

(30) Priority: 19.06.2024 JP 2024099020
(71) Applicant: Kioxia Corporation, Tokyo 105-0023 (JP)
(72) Inventor: Hatakeyama, Mina, Tokyo, 108-0023 (JP); Inuzuka, Yuki, Tokyo, 108-0023 (JP)
(74) Representative: Marks & Clerk LLP

(57) **Abstract**

A memory device includes a memory cell (MT), a word line (WL) coupled to the memory cell, a bit line (BL) coupled to the memory cell, a first transistor (T15), a first latch (ADL), a s-econd transistor (T9, T32), and a third transistor (T2,T31). The first transistor has a gate coupled to a first node (SEN) coupled to the bit line, and is coupled to a second node (LBUS). The first latch circuit is coupled to the second node and includes a third node (LATA). The second transistor is coupled between the first node and a fourth node (VHLB,CLKSA), with a gate coupled to a node (SPC) different from the third node. The third transistor is coupled between the first node and the fourth node, with a gate coupled to the third node. This arrangement enables controlled voltage application to the first node (SEN).

## Description

### CROSS-REFERENCE TO RELATED APPLICATION

This application is based upon and claims the benefit of priority from Japanese Patent Application No. 2024-99020, filed June 19, 2024, the entire contents of which are incorporated herein by reference.

### FIELD

Embodiments described herein relate generally to a memory device.

### BACKGROUND

A memory device can store data. The memory device that can store and read data at a high speed can be implemented for electronic devices such as a personal computer (PC), a mobile device, a server, table PC, Internet of Thing (IoT) device, etc.

### BRIEF DESCRIPTION OF THE DRAWINGS

FIG. 1 illustrates components and coupling of the components of a memory system that includes a memory device of a first embodiment.
FIG. 2 illustrates an example of components and coupling of the components of the memory device of the first embodiment.
FIG. 3 illustrates components and coupling of the components of a single block of the memory device of the first embodiment.
FIG. 4 illustrates an exploded view of the memory device of the first embodiment.
FIG. 5 illustrates an example of a partial cross-sectional structure of the memory device of the first embodiment.
FIG. 6 illustrates an example of a cross-sectional structure of a memory pillar of the memory device of the first embodiment along the xy plane.
FIG. 7 illustrates an example of distribution of threshold voltages of cell transistors of the memory device of the first embodiment each storing 3-bit data and the mapping of the data.
FIG. 8 illustrates the components and coupling of a sense amplifier of the memory device of the first embodiment.
FIG. 9 illustrates a circuit diagram of a sense amplifier circuit of the memory device of the first embodiment.
FIG. 10 illustrates, along time, the outline of a write operation in the memory device of the first embodiment.
FIG. 11 illustrates an example of setting of program loops in the write operation in the memory device of the first embodiment.
FIG. 12 illustrates verification voltages used in the memory device of the first embodiment and a part of a threshold voltage distribution.
FIG. 13 illustrates an electric characteristic of a cell transistor of the memory device of the first embodiment.
FIG. 14 illustrates, along time, potentials of a certain node based on the threshold voltage of a selected cell transistor during verification.
FIG. 15 illustrates the concept of verification in the memory device of the first embodiment.
FIG. 16 illustrates, along time, potentials of several nodes and signals during verification of the memory device of the first embodiment.
FIG. 17 illustrates an example of data in a latch circuit during verification of the memory device of the first embodiment.
FIG. 18 illustrates a state of a part of the sense amplifier circuit of the memory device of the first embodiment.
FIG. 19 illustrates a state of a part of the sense amplifier circuit of the memory device of the first embodiment.
FIG. 20 illustrates an example of data in the latch circuit during verification of the memory device of the first embodiment.
FIG. 21 illustrates an example of data in the latch circuit during verification of the memory device of the first embodiment.
FIG. 22 illustrates, along time, potentials of several nodes and signals during verification of a memory device of a modification of the first embodiment.
FIG. 23 illustrates a circuit diagram of a sense amplifier circuit of a memory device of a second embodiment.
FIG. 24 illustrates, along time, potentials of several nodes and signals during verification of the memory device of the second embodiment.
FIG. 25 illustrates, along time, the potentials of several nodes and signals during verification of a memory device of a modification of the second embodiment.

### DETAILED DESCRIPTION

In general, according to one embodiment, a memory device includes a memory cell, a word line coupled to the memory cell, a bit line coupled to the memory cell, a first transistor, a first latch, a second transistor, and a third transistor. The first transistor has a gate coupled to a first node coupled to the bit line, and is coupled to a second node. The first latch circuit is coupled to the second node and includes a third node. The second transistor is coupled between the first node and a fourth node. A gate of the second transistor is coupled to a node different from the third node. The third transistor is coupled between the first node and the fourth node A gate of the third transistor is coupled to the third node.

Embodiments will now be described with reference to the figures. In order to distinguish components having substantially the same function and configuration in an embodiment or over different embodiments from each other, an additional numeral or letter may be added to the end of each reference numeral or letter. For an embodiment subsequent to an embodiment that has already been described, the description will concentrate mainly on the matters that constitute a difference from the already described embodiment. The entire description of a particular embodiment applies to another embodiment unless an explicit mention is made otherwise, or an obvious elimination is involved.

The specification and the claims, when mentioning that a particular (first) component is "coupled" to another (second) component, intend to cover both the form of the first component directly coupled to the second component and the form of the first component coupled to the second component via one or more components which are always or temporarily conductive such as a switch.

Hereinafter, embodiments will be described using a three-dimensional orthogonal coordinate system. A direction of an x axis is referred to as an X direction. A direction opposite to the X direction is referred to as a -X direction. A direction of a y axis is referred to as a Y direction. A direction opposite to the Y direction is referred to as a -Y direction. A direction of a z axis is referred to as a Z direction, and up indicates the Z direction. A direction opposite to the Z direction is referred to as a -Z direction, and down indicates the -Z direction.

### 1. First Embodiment

### 1.1. Configuration (Structure)

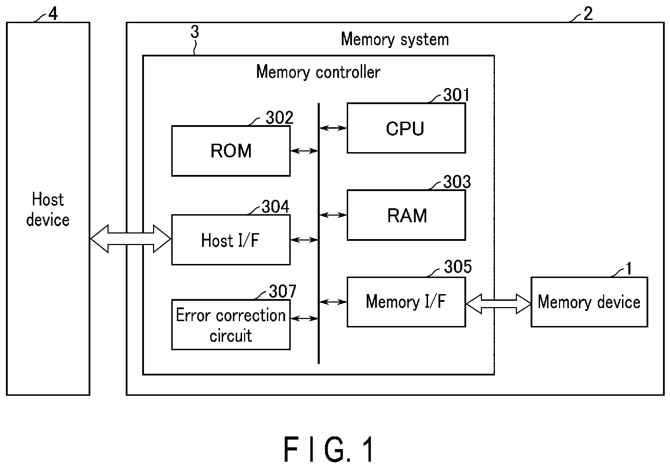

FIG. 1 illustrates an example of components and coupling of the components of a memory system that includes a memory device of a first embodiment.

As illustrated in FIG. 1, the memory system 2 includes a memory device 1 and a memory controller 3. The memory system 2 is a device that stores data. Examples of the memory system 2 include a memory card such as a SD^{™} card, a universal flash storage (UFS), and a solid state drive (SSD). The memory system 2 stores, reads, and erases data in response to a request from the host device 4. Examples of the host device 4 includes a personal computer and a sever in a data center.

The memory device 1 stores data using memory cells. The memory device 1 stores data to be written, and outputs data stored in the memory device 1. In one example, the memory device 1 is realized as a single chip.

In some embodiments, the memory controller 3 is a component or a controller that controls the memory device **1.** Examples of the form of the memory controller 3 include an integrated circuit such as a system on a chip (SoC). The memory controller 3 controls the memory device 1 to perform process requested by the host device 4. Specifically, the memory controller 3 writes write data in the memory device 1 based on a write request from the host device 4. The memory controller 3 reads read data from the memory device 1 and transmits data based on the read data based on a read request from the host device 4.

The memory controller 3 includes a central processing unit (CPU) 302, a read only memory (ROM) 302, a random access memory (RAM) 303, a host interface (host I/F) 304, a memory interface (memory I/F) 305, and an error correction circuit 307.

In some embodiments, the CPU 301 is a circuit that controls an overall operation of the memory controller 3. Through execution of programs stored in the ROM 302 and loaded onto the RAM 303 by the CPU 301, the memory controller 3 performs various operations.

In some embodiments, the ROM 302 is a nonvolatile memory. The ROM 302 stores programs including firmware.

In some embodiments, the RAM 303 is a volatile memory. The RAM 303 temporarily stores data, and stores programs stored in the ROM 302 while the memory system 2 is being supplied with a power supply.

In some embodiments, the host interface 304 is an interface for the memory controller 3 to communicate with the host device 4. The host interface 304 includes hardware or a combination of hardware and software. The host interface 304 is coupled to the host device 4 via an interconnect for enabling communications according to a scheme which the memory controller 3 and the host device 4 comply with.

In some embodiments, the memory interface 305 is an interface for the memory controller 3 to communicate with the memory device 1. The memory interface 305 includes hardware or a combination of hardware and software. The memory interface 305 is coupled to the memory device 1 via an interconnect for enabling communications according to a scheme based on a type of the memory device 1. The memory interface 305 transmits a command, address information, and write data to the memory device 1, and receives read data from the memory device 1. The memory interface 305 transmits various control signals for controlling the memory device 1 to the memory device 1.

The error correction circuit 307 performs process for detecting and correcting an error in data that will be written in the memory device 1, and performs detection and correction of an error in data read from the memory device 1. The error correction circuit 307 may be realized as an independent dedicated semiconductor chip, may be a circuit formed on a semiconductor substrate, or may be realized by the CPU 301 as a result of executing firmware. The error correction circuit 307 generates an error correction code from data (substantial write data) to be written in the memory device 1. The error correction code thus generated from the substantial write data is added to the substantial write data, based on a scheme of generation of the error correction code. The substantial write data, and the error correction code generated from the substantial write data are written in the memory device 1. The error correction circuit 307 corrects an error in the read data using the error correction code.

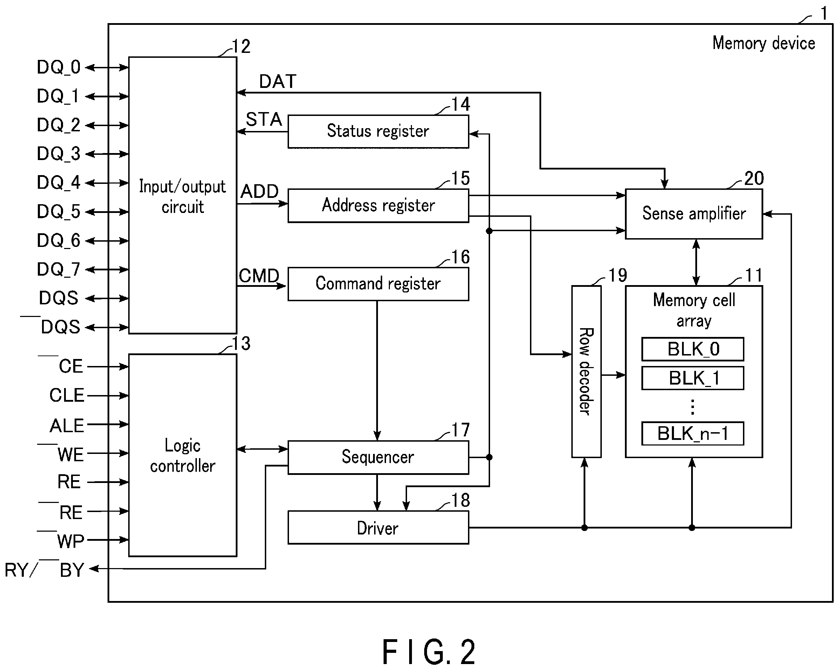

FIG. 2 illustrates an example of components and coupling of the components of the memory device of the first embodiment.

The memory device 1 includes components such as a memory cell array 11, an input/output circuit 12, a logic controller 13, a status register 14, an address register 15, a command register 16, a sequencer 17, a driver 18, a row decoder 19, and a sense amplifier 20.

The memory cell array 11 is a set of arrayed memory cells. The memory cell array 11 includes a plurality of memory blocks (or, blocks) BLK. Each block BLK includes a plurality of memory cells (or, cell transistors) MT (not shown). In an area in which the memory cell array 11 is provided, interconnects such as word lines WL (not shown) and bit lines BL (not shown) are also located.

The input/output circuit 12 transmits and receives various signals to and from the memory controller 3. The input/output circuit 12 transmits and receives input/output signals DQ (DQ_0, DQ_1, DQ_2, DQ_3, DQ_4, DQ_5, DQ_6, and DQ_7) and signals DQS and ⁻DQS. The symbol " " indicates inverted logic of logic of a signal of a name without the symbol " ", and indicates that a signal is asserted if the signal whose name includes the symbol "⁻" is at a low ("L") level. The set of input/output signals DQ_0 to DQ_7 functions as signals such as a command (CMD), write data or read data (DAT), address information (ADD), and status information (STA). The signals DQS and ⁻DQS indicate timing of taking in the input/output signals DQ_0 to DQ_7.

The logic controller 13 transmits and receives signals to and from the outside of the memory device, or, in one example, the memory controller 3. The logic controller 13 receives signals ⁻CE, CLE, ALE, ⁻WE, RE, ⁻RE, and ⁻WP. The signal ⁻CE indicates that the memory device 1 should be enabled. The signal CLE indicates transmission of the command CMD by the input/output signal DQ. The signal ALE indicates transmission of the address information ADD by the input/output signal DQ. The signal ⁻WE indicates that the input/output signal DQ should be taken in. The signal ⁻RE indicates timing of output of the input/output signal DQ.

The status register 14 temporarily stores the status information STA. The status information STA indicates a status or result for one or more of various items regarding the memory device 1. The status information STA is transmitted from the sequencer 17 and transmitted to the input/output circuit 12.

The address register 15 temporarily stores the address information ADD received by the memory device 1. In one example, the address information ADD includes a block address, a page address, and a column address. The block address, the page address, and the column address specify a block BLK, a word line WL, and a bit line BL, respectively. The address information ADD is received from the outside of the memory device 1, or, in one example, the memory controller 3, and transmitted to the address register 15.

The command register temporarily stores the command CMD received by the memory device 1. The command CMD instructs the memory device 1 to perform various operations including data read, data write, and data erase.

In some embodiments, the sequencer 17 is a circuit that controls an overall operation of the memory device 1. Based on the command CMD received from the command register 16, the sequencer 17 controls the driver 18, the row decoder 19, and sense amplifier 20 to perform various operations including data read, data write, and data erase. The sequencer 17 transmits a ready/busy signal RY/⁻BY. The ready/busy signal RY/⁻BY indicates whether the memory device 1 is in a ready state or in a busy state, and indicates the busy state by a low level. When the memory device 1 is in the ready state, the memory device 1 accepts the command CMD. When the memory device 1 is in the busy state, the memory device 1 does not accept the command CMD.

In some embodiments, the driver 18 is a circuit that applies various voltages necessary for the operation of the memory device 1 to several components. The driver 18 receives a power supply voltage from the outside of the memory device 1, and generates a plurality of voltages from the power supply voltage. The driver 18 supplies the generated voltages to the memory cell array 11, the sense amplifier 20, and the row decoder 19.

In some embodiments, the row decoder 19 is a circuit for selecting a block BLK. The row decoder 19 transfers the voltages supplied from the driver 18 to a single block BLK selected based on the block address received from the address register 15.

In some embodiments, the sense amplifier 20 is a circuit that determines data stored in the memory cell array 11. The sense amplifier 20 senses a state of the cell transistor MT, generates read data based on the sensed state. The generated read data DAT is transmitted to the input/output circuit 12. The sense amplifier 20 receives the write data DAT and transfers the received write data DAT to the cell transistor MT.

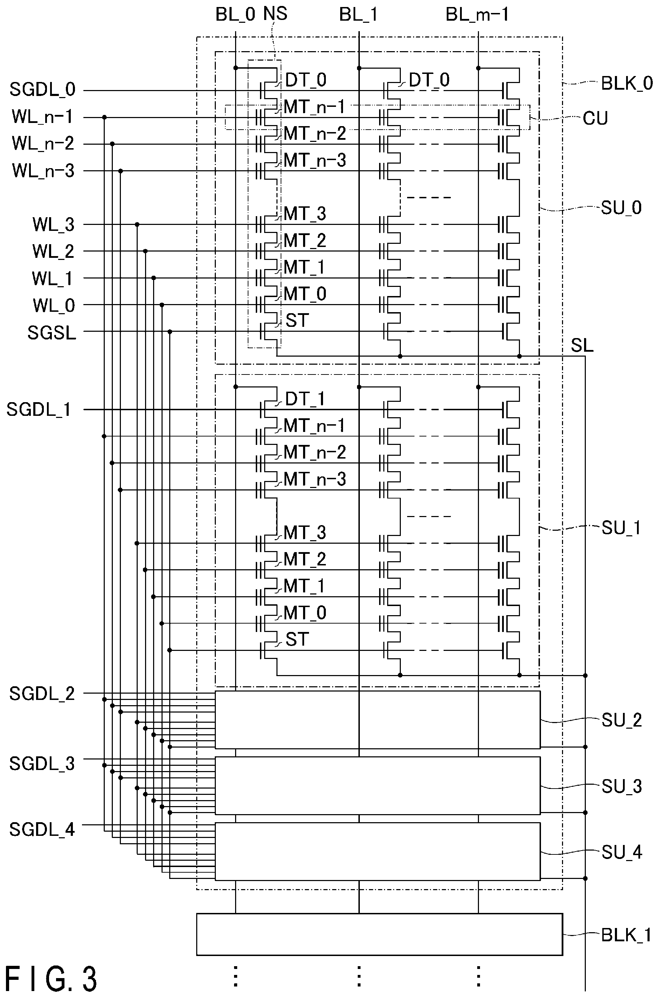

FIG. 3 illustrates components and coupling of the components of a single block of the memory device of the first embodiment. A plurality of blocks BLK, for example, all blocks BLK, include the components and the coupling illustrated in FIG. 3.

A single block BLK includes a plurality of string units SU. FIG. 3 illustrates an example of five string units SU_0 to SU_4.

As illustrated in FIG. 3, each of m-number of bit lines BL_0 to BL_m-1 is coupled, in each block BLK, to a single NAND string NS from each of string units SU_0 to SU_4., where m is a positive integer.

Each NAND string NS includes a single select gate transistor ST, n-number of cell transistors MT, and a single select gate transistor DT (DT_0, DT_1, DT_2, DT_3, or DT_4), where n is a positive integer. The cell transistor MT is an element that functions as a memory cell and stores data in a nonvolatile manner. The cell transistor MT (MT_0 to MT_n-1) includes a control gate electrode or gate electrode (or, word line WL) and a charge accumulation film insulated from the surrounding, and stores data in a nonvolatile manner based on charge in the charge accumulation film. Data is written to the cell transistor MT by injecting electrons into the charge accumulation film.

The select gate transistors ST, cell transistors MT_0 to MT_n-1, and select gate transistor DT are coupled in series in the named order between a source line SL and a single bit line BL.

A plurality of NAND strings NS respectively coupled a plurality of different bit lines BL constitute a single string unit SU. In each string unit SU, the control gate electrodes of the cell transistors MT_0 to MT_n-1 are coupled to the word lines WL_0 to WL_n-1, respectively. A set of cell transistors MT, which share a single word line WL in one string unit SU, is called "cell unit CU".

The select gate transistors DT_0 to DT_4 belong to the string units SU_0 to SU_4, respectively. In FIG. 3, the select gate transistors DT_2, DT_3, and DT_4 are not illustrated. The gate of the select gate transistor DT_0 of each of the NAND strings NS of the string unit SU_0 is coupled to a select gate line SGDL_0. Similarly, the gates of the select gate transistors DT_1, DT_2, DT_3, and DT_4 of the respective NAND strings NS of the string units SU_1, SU_2, SU_3, and SU_4 are coupled to select gate lines SGDL_1, SGDL_2, SGDL_3, and SGDL_4.

The gate of the select gate transistor ST is coupled to a select gate line SGSL.

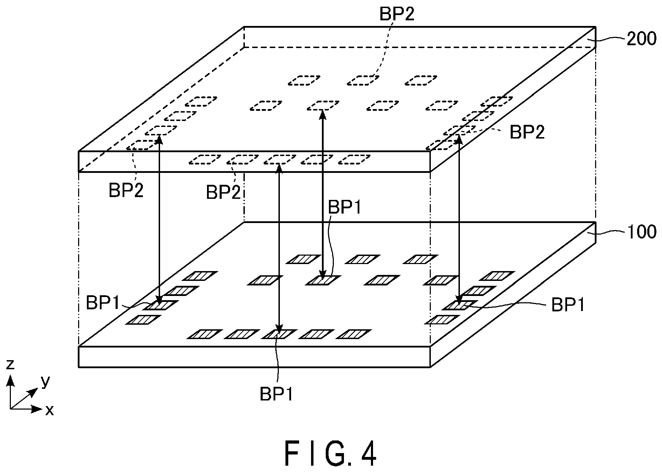

FIG. 4 illustrates an exploded view of the memory device of the first embodiment. As illustrated in FIG. 4, the memory device 1 includes a first structure 100 and a second structure 200. The first structure 100 and the second structure 200 spread along the xy plane and are arranged along the z axis. The second structure 200 is located on an upper surface of the first structure 100.

The first structure 100 and the second structure 200 each include semiconductors, conductors, and insulators formed on a substrate using the substrate. The first structure 100 and the second structure 200 each include elements and interconnects realized by the semiconductors, conductors, and insulators. The first structure 100 and the second structure 200 each include an electric circuit including elements and interconnects. The elements and interconnects in the first structure 100 and the elements and interconnects in the second structure 200 are electrically coupled to each other.

The set of the first structure 100 and the second structure 200 includes the memory cell array 11, the input/output circuit 12, the logic controller 13, the status register 14, the address register 15, the command register 16, the sequencer 17, the driver 18, the row decoder 19, and the sense amplifier 20.

The first structure 100 includes conductive joint terminals BP1. The joint terminals BP1 are exposed on the upper surface of the first structure 100. The joint terminals BP1 are coupled to elements inside the first structure 100.

The second structure 200 includes conductive joint terminals BP2. The joint terminals BP2 are exposed on a lower surface of the second structure 200. The joint terminals BP2 are coupled to elements inside the second structure 200. The joint terminals BP2 have the same layout as layout of the joint terminals BP1 of the first structure 100. The joint terminals BP2 are arranged such that when the first structure 100 and the second structure 200 are joined, each joint terminal BP2 makes contact with one of the joint terminals BP1 of the first structure 100 corresponding to the joint terminal BP2. A specific joint terminal BP2 and the one of the joint terminals BP1 of the first structure 100 corresponding to the specific joint terminal BP2 are elements that function as the same node in the circuit.

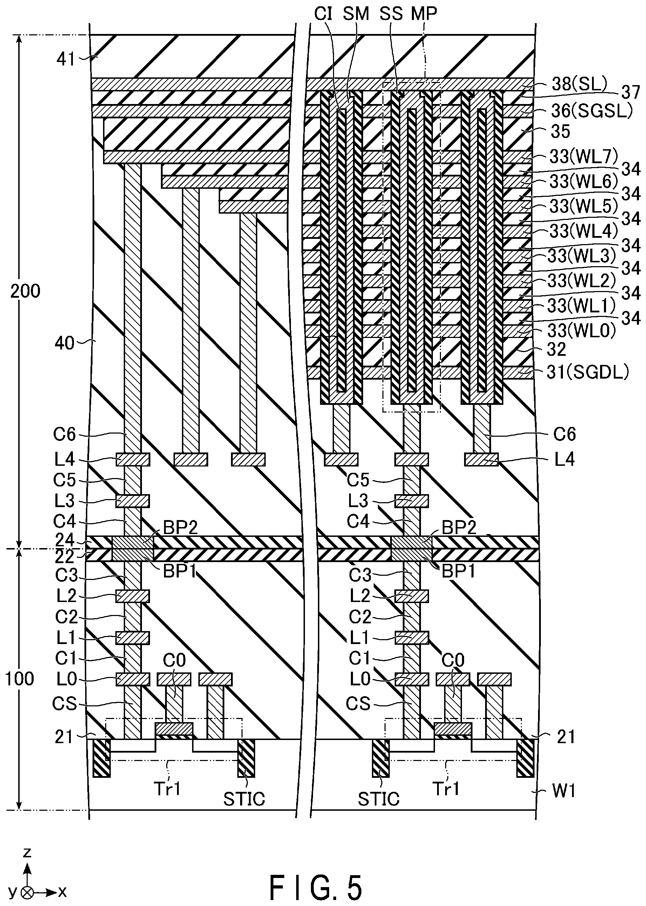

FIG. 5 illustrates an example of a partial cross-sectional structure of the memory device of the first embodiment. As illustrated in FIG. 5, the first structure 100 further includes a substrate W1, structures STIC, transistors Tr1, contacts CS, C0, C1, C2, and C3, conductors L0, L1, and L2, and insulators 21 and 22. In the following description, the conductor also includes a semiconductor which has conductivity by containing impurities. In one example, the substrate W1 includes silicon. In one example, the contacts CS, C0, C1, C2, and C3, and the conductors L0, L1, and L2 include copper or tungsten. In one example, the insulators 21 and 22 include silicon oxide.

The structure STIC has a shallow trench isolation (STI) structure. The structure STIC extends along the z axis from an upper surface of the substrate W1 in the substrate W1. In one example, the structure STIC includes silicon oxide.

The transistor Tr1 is located in a region above and near the upper surface of the substrate W1. The transistor Tr1 includes a gate insulator on the upper surface of the substrate W1, a gate electrode on an upper surface of the gate insulator, and a pair of source/drain regions sandwiching a region below the gate electrode.

Each contact C0 is in contact, at its lower surface, with an upper surface of the gate electrode of a single transistor Tr1. Each contact CS is in contact, at its lower surface, with a single source/drain region.

Each conductor L0 is in contact, at its lower surface, with a single contact C0 or CS. Each contact C1 is in contact, at its lower surface, with an upper surface of a single conductor L0.

Each conductor L1 is in contact, at its lower surface, with an upper surface of a single contact C1. Each contact C2 is in contact, at its lower surface, with an upper surface of a single conductor L1 on the lower surface.

Each conductor L2 is in contact, at its lower surface, with an upper surface of a single contact C2. Each contact C3 is in contact, at its lower surface, with an upper surface of a single conductor L2.

A set of the transistors Tr1, the contacts CS, C0, C1, C2, and C3, and the conductors L0, L1, and L2 realizes a circuit included in the first structure 100. Therefore, the first structure 100 includes the transistors Tr1, the contacts CS, C0, C1, C2, and C3, and the conductors L0, L1, and L2, which have any shapes and arrangements to realize the circuit included in the first structure 100.

The insulator 21 ranges from a level of the upper surface of the substrate W1 to a level of an upper surface of the contact C3. The insulator 21 fills a region where the transistors Tr1, the contacts CS, C0, C1, C2, and C3, and the conductors L0, L1, and L2 are not provided.

Each joint terminal BP1 is in contact, at its lower surface, with the upper surface of a single contact C3. The insulator 22 fills a region in the layer in which the joint terminal BP1 is located where the joint terminals BP1 are not provided.

The second structure 200 further includes contacts C4, C5, and C6, conductors L3, L4, 31, 33, 36, 38, insulators 24, 32, 34, 35, 37, 40, and 41, and memory pillars MP.

Each joint terminal BP2 is located in a lowermost layer of the second structure 200. The insulator 24 fills a region in a layer in which the joint terminals BP2 are located where the joint terminals BP2 are not provided.

Each contact C4 is in contact, at its lower surface, with an upper surface of a single joint terminal BP2. Each conductor L3 is in contact, at its lower surface, with an upper surface of a single contact C4.

Each contact C5 is in contact, at its lower surface, with an upper surface of a single conductor L3. Each conductor L4 is in contact, at its lower surface, with an upper surface of a single contact C5.

The conductor 31 is located above the conductor L4. The conductor 31 has a plate shape along the xy plane. The conductor 31 functions as at least a part of a select gate line SGDL. A lower surface of the conductor 31 is exposed at an edge and has a terrace.

An insulator 32 is located on an upper surface of the conductor 31. The insulator 32 has a plate shape along the xy plane.

The conductors 33 and the insulators 34 are stacked one by one alternately on an upper surface of the insulator 32. The conductors 33 and the insulators 34 have a plate shape along the xy plane. Each conductor 33 functions as at least a part of a word line WL. FIG. 5 illustrates an example where n, that is, the number of a cell transistors MT is 8. The conductors 33 function as at least a part of the word lines WL0, WL1, WL2, WL3, WL4, WL5, WL6, and WL7 in the named order from the bottom. A lower surface of each conductor 33 is exposed at an edge and has a terrace.

The insulator 35 is located on an upper surface of the uppermost conductor 33.

The conductor 36 is located on an upper surface of the insulator 35. The conductor 36 functions as at least a part of the select gate line SGSL.

The insulator 37 is located on an upper surface of the conductor 36. The conductor 38 is located on an upper surface of the insulator 37. A lower surface of the conductor 38 is exposed at an edge and has a terrace.

The memory pillar MP extends along the z axis and penetrates the set of the conductors 31, 33, and 36, and the insulators 32, 34, 35, and 37. The memory pillar MP includes an insulator CI, a semiconductor SM, and a layer stack SS. The semiconductor SM covers a side surface of the insulator CI. The layer stack SS covers a side surface of the semiconductor SM. The layer stack SS is open at an upper end of the memory pillar MP. Part of the semiconductor SM is located in the opening and is in contact, at its upper surface, with the conductor 38.

An upper part of the memory pillar MP may be located inside the conductor 38, the layer stack SS may be open in a portion facing the conductor 38, and part of the semiconductor SM may be located inside the opening.

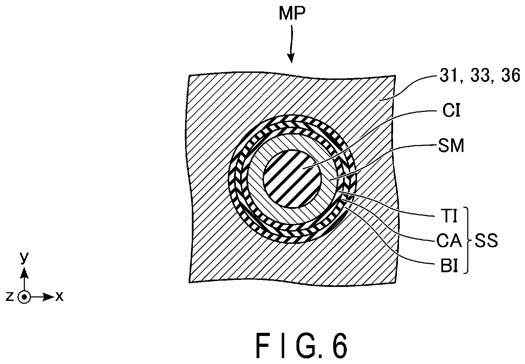

FIG. 6 illustrates an example of a cross-sectional structure of the memory pillar of the memory device of the first embodiment along the xy plane. As illustrated in FIG. 6, in one example, the layer stack SS includes a tunnel insulator TI, a charge accumulation film CA, and a block insulator BI.

The tunnel insulator TI surrounds a side surface of the semiconductor SM. The charge accumulation film CA surrounds a side surface of the tunnel insulator TI. The block insulator BI surrounds a side surface of the charge accumulation film CA. The conductor 31, 33 or 36 surrounds the side surface of the block insulator BI.

The semiconductor SM functions as a channel (or, current path) for the cell transistor MT and the select gate transistors DT and ST. In one example, each of the tunnel insulator TI and the block insulator BI includes silicon oxide. The charge accumulation film CA accumulates charge. In one example, the charge accumulation film CA includes silicon nitride.

Referring back to FIG. 5, a part of the memory pillar MP that faces the conductor 31 functions as a single select gate transistor DT. A part of the memory pillar MP that faces the conductor 33 functions as a single cell transistor MT. A part of the memory pillar MP that faces the conductor 36 functions as a single select gate transistor ST. A lower surface of the semiconductor SM is exposed on the lower surface of each memory pillar MP. A lower surface of the semiconductor SM is exposed on an upper surface of the memory pillar MP.

Each contact C6 is in contact, at its lower surface, with an upper surface of a single conductor L4. Each of some contacts C6 is in contact, at is upper surface, with a lower surface of the semiconductor SM of a single memory pillar MP. Each of some contacts C6 is in contact, at its upper surface, with a lower surface of the terrace portion of a single conductor of the conductors 31, 33, and 37 on the upper surface.

The insulator 40 ranges from a level of an upper surface of the insulator 24 to a level of an upper surface of the conductor 38. The insulator 40 fills a region of the second structure 200 where the contacts C4, C5, and C6, the conductors L3, L4, 31, 33, 36, 38, the insulators 40, 32, 34, 35, 37, and the memory pillars MP are not provided.

The insulator 41 is located on the upper surface of each of the conductor 38 and the insulator 40.

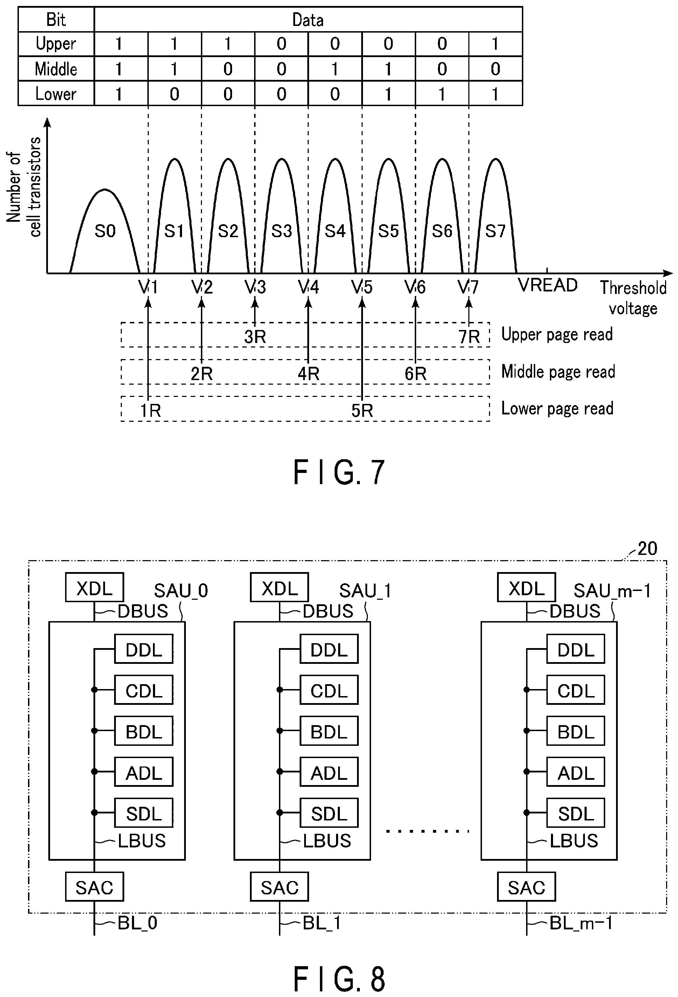

The memory device 1 can store two or more bits of data in a single cell transistor MT. FIG. 7 illustrates an example of distribution of threshold voltages of the cell transistors MT of the memory device 1 of the first embodiment each storing 3-bit data and the mapping of the data. The threshold voltage of each cell transistor MT has a magnitude corresponding to the stored data based on the amount of electrons in the charge storage film CA. In the case of 3-bit storage, each cell transistor MT is in one of "S0", "S1", "S2", "S3", "S4", "S5", "S6", and "S7" sates based on the threshold voltage. The cell transistors MT in the "S0", "S1", "S2", "S3", "S4", "S5", "S6", and "S7" states have higher threshold voltages in the named order. The cell transistor MT is brought to the "S0" state when the threshold voltage of the cell transistor MT is lowered through the data erase.

Through the data write, a write target cell transistor MT is maintained in the "S0" state or brought to any one of the "S1", "S2", "S3", "S4", "S5", "S6", and "S7" states based on the data to be written. Even a plurality of cell transistors MT that store the same 3-bit data may have different threshold voltages. A set of threshold voltages in a single state is referred to as a threshold voltage lobe.

3-bit data can be assigned to any state. In one example, each state is treated as having the following 3-bit data. Regarding "ABC" in the following description, A, B, and C indicate values of upper, middle, and lower bits, respectively.
The "S0" state: "111"
The "S1" state: "110"
The "S2" state: "100"
The "S3" state: "000"
The "S4" state: "010"
The "S5" state: "011"
The "S6" state: "001"
The "S7" state: "101"

The data read is based on determination of the state of a read target cell transistor MT. Read voltages VCGR having different magnitudes are used for the determination of the state. While the cell transistor MT is receiving the read voltage VCGR at its gate electrode, the cell transistor remains off if the cell transistor MT has a threshold voltage equal to or higher than the read voltage VCGR, and remains on if the cell transistor MT has a threshold voltage lower than the read voltage VCGR. Based on this, it is determined whether the read target cell transistor MT has a threshold voltage higher than the read voltage VCGR.

Determination whether the read target cell transistor MT is in a state higher than the "S0", "S1", "S2", "S3", "S4", "S5", and "S6 states is performed using read voltages V1, V2, V3, V4, V5, V6, and V7, respectively. The read voltages V1, V2, V3, V4, V5, V6, and V7 are higher in the named order. Obtaining a set of bits indicating whether the cell transistors MT are on or off by application of the read voltages V1, V2, V3, V4, V5, V6, and V7, or data read, are referred to as 1R, 2R, 3R, 4R, 5R, 6R, and 7R, respectively.

A set of data of bits (or, bit string) at the same position (or, digit) in the cell transistors MT of a single cell unit CU constitutes a single page. A set of data of the least significant (i.e., first digit from the bottom) bits (or, bit string), or lower bits, of the cell transistors MT of each cell unit CU is referred to as a lower page. A set of data of the second least significant bits (or, bit string), or middle bits, of the cell transistors MT of each cell unit CU is referred to as a middle page. A set of data of the third least significant bits, or upper bits, of the cell transistors MT of each cell unit CU is referred to as an upper page.

Read of the lower page uses the 1R and 5R. Data of the lower page can be determined through the 1R and 5R.

Read of the middle page uses the 2R, 4R, and 6R. Data of the middle page can be determined through the 2R, 4R, and 6R.

Read of the upper page uses the 3R and 7R. Data of the upper page can be determined through the 3R and 7R.

The voltage VREAD has a magnitude that turns on the cell transistor MT regardless of the data stored in the cell transistor MT.

FIG. 8 illustrates the components and coupling of a sense amplifier of the memory device of the first embodiment. The sense amplifier 20 includes a plurality of latch circuits XDL, and sense amplifier units SAU as many as the bit lines BL. Each sense amplifier unit SAU includes a sense amplifier circuit SAC, and a plurality of, for example, fives latch circuits SDL, ADL, BDL, CDL, and DDL.

The latch circuits SDL, ADL, BDL, CDL, and DDL are coupled to a bus LBUS. Each of the latch circuits SDL, ADL, BDL, CDL, and DDL can store 1-bit data.

The latch circuit XDL is coupled to one sense amplifier unit SAU via a bus DBUS. The bus DBUS is coupled to the input/output circuit 12.

The sense amplifier circuit SAC is coupled to a single bus LBUS and a single bit line BL. The sense amplifier circuit SAC is coupled to a single selected cell transistor MT via a single bit line BL coupled to itself during data read. The selected cell transistor MT is a cell transistor MT selected as the target of data read or data write. Each sense amplifier circuit SAC senses, on a node (node SEN to be described later) in the sense amplifier circuit SAC, a voltage whose magnitude is determined based on the threshold voltage of the selected cell transistor MT. Based on the result of sense, the sense amplifier circuit SAC outputs data indicating to which one of two state the cell transistor MT belongs. The two states of the cell transistor MT are expressed as "0" data and "1" data. The data is stored in a latch circuit SDL coupled to the sense amplifier circuit SAC.

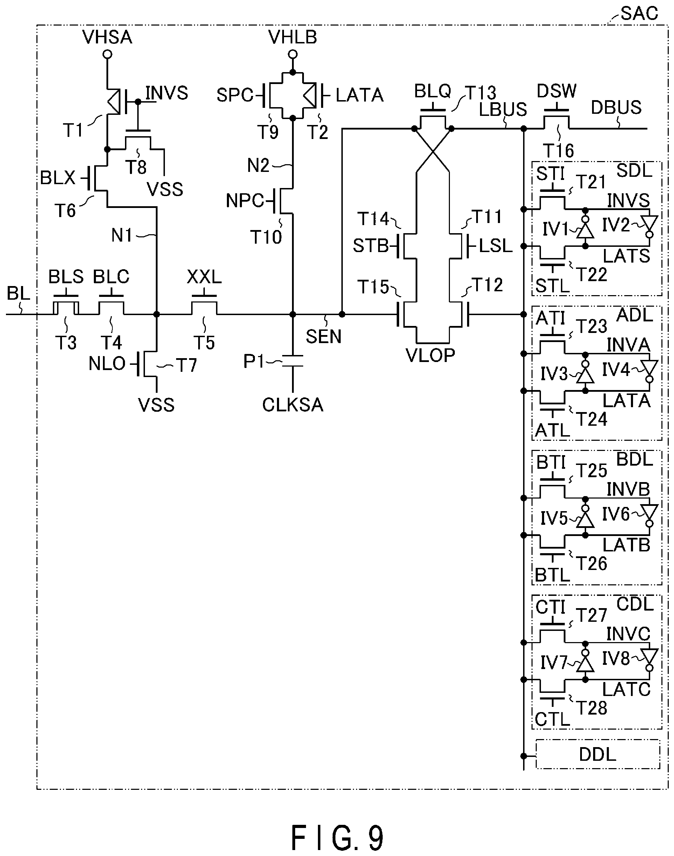

FIG. 9 illustrates a circuit diagram of the sense amplifier circuit of the memory device of the first embodiment. Each sense amplifier circuit SAC may include p-type metal oxide semiconductor field effect transistors (MOSFETs) T1 and T2, n-type MOSFETs T3, T4, T5, T6, T7, T8, T9, T10, T11, T12, T13, T14, T15, and T16, and a capacitor P1.

The transistors T3 and T4 are coupled, in this order, in series between a node N1 and a single bit line BL coupled to the sense amplifier circuit SAC illustrated in FIG. 9. The transistor T3 receives a signal BLS at the gate. The transistor T4 receives a signal BLC at the gate.

The transistor T5 is coupled between the node N1 and the node SEN. The transistor T5 receives a signal XXL at the gate.

The transistors T1 and T6 are coupled, in this order, in series between a node VHSA and the node N1. The node VHSA receives the power supply voltage of the sense amplifier 20 from the driver 18. The transistor T1 is coupled to a node INVS at the gate. The transistor T6 receives a signal BLX at the gate.

The transistor T7 is coupled between the node N1 and a node VSS. The node VSS receives the ground voltage VSS from the driver 18 or the memory controller 3. The transistor T7 receives a signal NLO at the gate.

The transistor T8 is coupled between a node to which the transistor T1 and the transistor T6 are coupled and the node VSS. The transistor T8 is coupled to the node INVS at the gate.

The transistors T2 and T9 are coupled in parallel between a node VHLB and a node N2. The node VHLB receives a voltage VHLB from the driver 18. The transistor T2 is coupled to a node LATA at the gate. The transistor T9 receives a signal SPC at the gate.

The transistor T10 is coupled between the node N2 and the node SEN. The transistor T10 receives a signal NPC at the gate.

The capacitor P1 is coupled between the node SEN and a node CLKSA. In an example, the node CLKSA receives a voltage from the driver 18.

The transistors T11 and T12 are coupled, in this order, in series between the node SEN and a node VLOP. The transistor T11 receives a signal LSL at the gate. The transistor T12 is coupled to the bus LBUS at the gate.

The transistor T13 is coupled between the node SEN and the bus LBUS. The transistor T13 receives a signal BLQ at the gate.

The transistors T14 and T15 are coupled, in this order, in series between the bus LBUS and the node VLOP. The transistor T14 receives a signal STB at the gate. The transistor T15 is coupled to the node SEN at the gate.

The transistor T16 is coupled between the bus LBUS and the bus DBUS. The transistor T16 receives a signal DSW at the gate.

The latch circuit SDL includes n-type MOSFETs T21 and T22, and inverter circuits IV1 and IV2.

The transistor T21 is coupled between the bus LBUS and the node INVS. The transistor T21 receives a signal STI at the gate.

The transistor T22 is coupled between the bus LBUS and a node LATS. The transistor T22 receives a signal STL at the gate.

The inverter circuit IV1 is coupled to the node LATS at the input and coupled to the node INVS at the output.

The inverter circuit IV2 is coupled to the node INVS at the input and coupled to the node LATS at the output.

The latch circuit ADL includes n-type MOSFETs T23 and T24, and inverter circuits IV3 and IV4.

The transistor T23 is coupled between the bus LBUS and a node INVA. The transistor T23 receives a signal ATI at the gate.

The transistor T24 is coupled between the bus LBUS and node LATA. The transistor T24 receives a signal ATL at the gate.

The inverter circuit IV3 is coupled to the node LATA at the input and coupled to the node INVA at the output.

The inverter circuit IV4 is coupled to the node INVA at the input and coupled to the node LATA at the output.

The latch circuit BDL includes n-type MOSFETs T25 and T26, and inverter circuits IV5 and IV6.

The transistor T25 is coupled between the bus LBUS and a node INVB. The transistor T25 receives a signal BTI at the gate.

The transistor T26 is coupled between the bus LBUS and a node LATB. The transistor T26 receives a signal BTL at the gate.

The inverter circuit IV5 is coupled to the node LATB at the input and coupled to the node INVB at the output.

The inverter circuit IV6 is coupled to the node INVB at the input and coupled to the node LATB at the output.

The latch circuit CDL includes n-type MOSFETs T27 and T28, and inverter circuits IV7 and IV8.

The transistor T27 is coupled between the bus LBUS and a node INVC. The transistor T27 receives a signal CTI at the gate.

The transistor T28 is coupled between the bus LBUS and a node LATC. The transistor T28 receives a signal CTL at the gate.

The inverter circuit IV7 is coupled to the node LATC at the input and coupled to the node INVC at the output.

The inverter circuit IV8 is coupled to the node INVC at the input and coupled to the node LATC at the output.

The latch circuit DDL has the same configuration as the latch circuits SDL, ADL, BDL, and CDL.

In an example, one, some, or all of the signals BLS, BLC, XXL, BLX, NLO, LSL, BLQ, and STB are suppled from the sequencer 17.

### 1.2. Operation

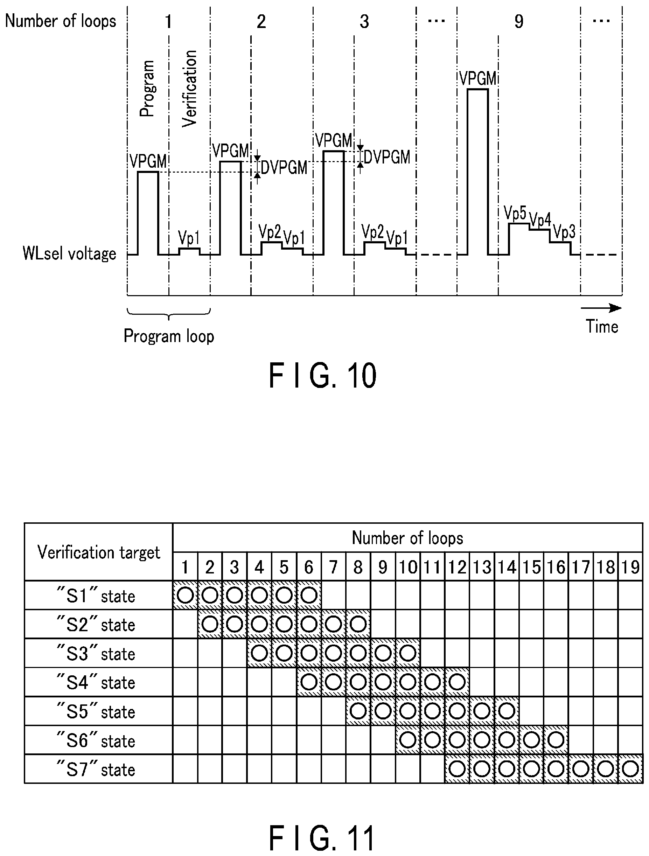

FIG. 10 illustrates, along time, the outline of a write operation in the memory device of the first embodiment. As illustrated in FIG. 10, the memory device 1 repetitively executes a program loop during a write operation. FIG. 10 illustrates the number of times of executing the program loop (to be referred to as a loop count hereinafter), and the voltage (WLsel voltage) of a selected word line WLsel. The selected word line WLsel is a word line WL coupled to the cell unit CU that is the target of data write (or, write operation). Each program loop includes program and verification.

In some embodiments, program operation (also referred to as "program" herein) is an operation for raising the threshold voltage of the cell transistor MT. During program, a selected cell transistor MTsel is set to a program state or a program inhibition state. The selected cell transistor MTsel is a cell transistor MT coupled to the selected word line WLsel. Which one of the program state and the program inhibition state is to be set depends on the target state of each selected cell transistor MTsel. The target state is a state to which each selected cell transistor MTsel is transitioned based on data to be written. If the selected cell transistor MTsel has a threshold voltage less than a voltage determined to be included in the target state, it is set to the program state. If the selected cell transistor MTsel has a threshold voltage equal to or more than a voltage determined to be included in the target state, it is set to the program inhibition state.

During program, a program voltage VPGM having a variable magnitude is applied to the selected word line WLsel. The program voltage VPGM is a high voltage capable of raising the threshold voltage of the selected cell transistor MTsel.

The program voltage VPGM is increased every time the loop count increases. A width DVPGM of the program voltage VPGM can have any magnitude. When the program voltage VPGM is applied to the selected word line WLsel, the threshold voltage of the selected cell transistor MTsel in the program state rises. A rise of the threshold voltage of the selected cell transistor MTsel in the program inhibition state is suppressed.

In some embodiments, verification operation (also referred to as "verification" herein) is an operation of confirming whether the threshold voltage of the selected cell transistor MTsel is a threshold voltage equal to or more than a voltage determined to be included in the target state, and is a read operation. In the verification or read operation, the signal STB is asserted, thereby storing data based on the potential of the node SEN in the latch circuit SDL, ADL, BDL, CDL, or DDL. The operation of storing the data based on the potential of the node SEN in the latch circuit SDL, ADL, BDL, CDL, or DDL in the verification or read operation will be referred to as a sense operation hereinafter.

The sequencer 17 executes verification for a selected cell transistor MTsel having a specific target state in each program loop.

In verification, it is determined whether the threshold voltage of the selected cell transistor MTsel is equal to or more than a verification voltage Vp having a variable magnitude. Each sense amplifier unit SAU outputs data based on whether the threshold voltage of the selected cell transistor MTsel coupled to itself is equal to or more than the verification voltage Vp. If the threshold voltage of the selected cell transistor MTsel is equal to or more than the verification voltage Vp, data indicating that the selected cell transistor MTsel has passed the verification is output. The verification voltage Vp has a magnitude depending on the target state, and is lower than the threshold voltage that the selected cell transistor MTsel considered to have been transitioned to the target state should at least have. In an example, verification voltages Vp1, Vp2, Vp3, Vp4, Vp5, Vp6, and Vp7 for "S0", "S1"**,** "S2", "S3", "S4", "S5", "S6", and "S7" states equal read voltages V1, V2, V3, V4, V5, V6, and V7, respectively. In another example, the verification voltages Vp1, Vp2, Vp3, Vp4, Vp5, Vp6, and Vp7 are slightly lower than the read voltages V1, V2, V3, V4, V5, V6, and V7, respectively.

On the other hand, if the threshold voltage of the selected cell transistor MTsel is less than the verification voltage Vp, data indicating that the selected cell transistor MTsel has failed the verification is output. Each sense amplifier unit SAU stores the data indicating the result of verification in the internal latch circuit ADL, BDL, CDL, or DDL. When the verification in a certain program loop is completed, the sequencer 17 sets each selected cell transistor MTsel in the program state or the program inhibition state based on the verification result, and starts the next program loop.

The memory device 1 can execute a detection operation after any program loop. In the detection operation, the number of selected cell transistors MTsel that have passed verification is counted for each target state. Based on the count value, the sequencer 17 determines, for each target state, whether write of the target state is completed. In one example, if the count value exceeds a certain ratio of m (that is, the number of cell transistors MT in a single cell unit CU), it is determined that write is completed.

FIG. 11 illustrates an example of setting of a program loop in the write operation in the memory device of the first embodiment. FIG. 11 illustrates the relationship between the number of loops and the target state of a verity target assigned to each loop. The target state of a verification target is indicated by a white circle.

As illustrated in FIG. 11, the types and number of verification targets change in accordance with the progress of the program loop. In the example illustrated in FIG. 11, the sequencer 17 executes the program loop 19 times at maximum. The maximum count of the program loop is decided in advance, based on the characteristic of the memory device 1, to the count with which it is considered or assumed that the write operation is completed (that is, the rise of the threshold voltage of the selected cell transistor MTsel whose target state is the highest state is completed).

In each program loop, the sequencer 17 executes verification for at least one state as the target. More specifically, "S1" state is set to the verification target in the first to sixth program loops. "S2" state is set to the verification target in the second to eighth program loops. "S3" state is set to the verification target in the fourth to 10th program loops. "S4" state is set to the verification target in the sixth to 12th program loops. "S5" state is set to the verification target in the eighth to 14th program loops. "S6" state is set to the verification target in the 10th to 16th program loops. "S7" state is set to the verification target in the 12th to 19th program loops. In the final program loop, verification may be omitted. This is because write is assumed to be completed by the final program loop.

In verification of each target state, it is determined to which one of four ranges the threshold voltage of the selected cell transistor MTsel belongs. Verification in program for the selected cell transistor MTsel in "S0 state" will be described below as a representative example. The remaining states are the same as "S0 state" except that the heights of the four threshold voltage ranges change depending on the state.

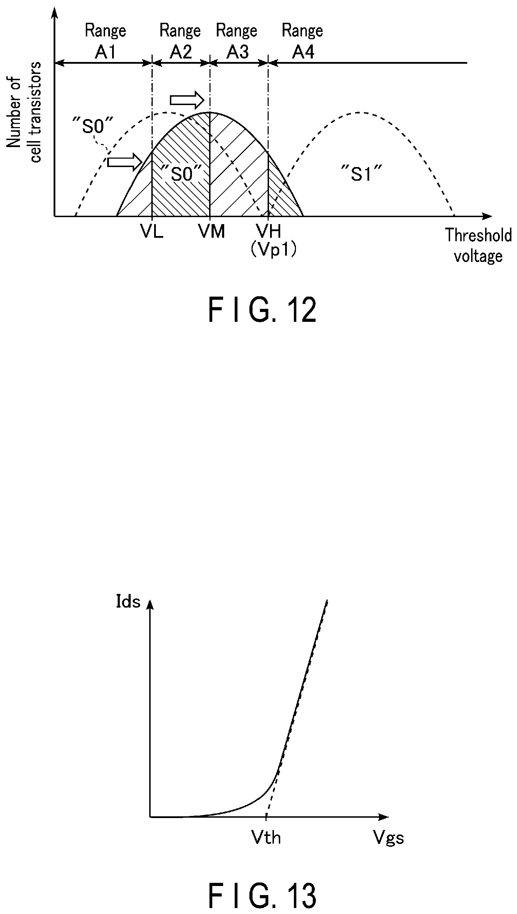

FIG. 12 illustrates verification voltages used in the memory device of the first embodiment and an example of a threshold voltage distribution. The four voltage ranges include ranges A1, A2, A3, and A4. The range A1 is a range less than a voltage VL. The range A2 is a range of the voltage VL or more and less than a voltage VM. The range A3 is a range of the voltage VM or more and less than a voltage VH. The range A4 is a range of the voltage VH or more. The voltages VL, VM, and VH are high in this order. The voltage VH is the verification voltage Vp for the target state. That is, based on the example of program for the selected cell transistor MTsel in "S0 state", the voltage VH is the voltage Vp1.

A sense operation of generating data indicating whether the threshold voltage of the selected cell transistor MTsel is less than the voltage VL or equal to or more than VL will be referred to as a VL sense operation. The VL sense operation is equivalent to determining whether the selected cell transistor MTsel has a threshold voltage less than the voltage VL or a threshold voltage equal to or more than the voltage VL.

A sense operation of generating data indicating whether the threshold voltage of the selected cell transistor MTsel is less than the voltage VM or equal to or more than VM will be referred to as a VM sense operation. The VM sense operation is equivalent to determining whether the selected cell transistor MTsel has a threshold voltage less than the voltage VM or a threshold voltage equal to or more than the voltage VM.

A sense operation of indicating whether the threshold voltage of the selected cell transistor MTsel is less than the voltage VH or equal to or more than VH will be referred to as a VH sense operation. The VH sense operation is equivalent to determining whether the selected cell transistor MTsel has a threshold voltage less than the voltage VH or a threshold voltage equal to or more than the voltage VH.

By the VL sense operation, the VM sense operation, and the VH sense operation, the range to which the threshold voltage of the selected cell transistor MTsel belongs can be determined.

In a certain program loop, the selected cell transistor MTsel determined by the VL sense operation to have a threshold voltage less than the voltage VL is determined to have a threshold voltage less than the verification voltage VH (= Vp1) of the target state. For this reason, the selected cell transistor MTsel is set in the program state by program in the next program loop. In the program for the selected cell transistor MTsel that is determined to have a threshold voltage less than the voltage VL and set in the program state, a first program condition for largely raising the threshold voltage of the selected cell transistor MTsel is used. The selected cell transistor MTsel to which the first program condition is applied, that is, which is determined to have a threshold voltage belonging to the range A1 may be referred to as a selected cell transistor MTsel1.

In a certain program loop, the selected cell transistor MTsel determined by the VL sense operation to have a threshold voltage equal to or more than the voltage VL and determined by the VM sense operation to have a threshold voltage less than the voltage VM is determined to have a threshold voltage less than the verification voltage VH of the target state. For this reason, the selected cell transistor MTsel is set in the program state by program in the next program loop. In the program for the selected cell transistor MTsel that is determined to have a threshold voltage equal to or more than the voltage VL and less than the voltage VM and set in the program state, if the first program condition is used, the threshold voltage of the selected cell transistor MTsel may excessively rise. For this reason, a second program condition for raising the threshold voltage of the selected cell transistor MTsel smaller than the rise amount under the first program condition is used. The selected cell transistor MTsel to which the second program condition is applied, that is, which is determined to have a threshold voltage belonging to the range A2 may be referred to as a selected cell transistor MTsel2.

In a certain program loop, the selected cell transistor MTsel determined by the VM sense operation to have a threshold voltage equal to or more than the voltage VM and determined by the VH sense operation to have a threshold voltage less than the voltage VH is determined to have a threshold voltage less than the verification voltage VH of the target state. For this reason, the selected cell transistor MTsel is set in the program state by program in the next program loop. In the program for the selected cell transistor MTsel that is determined to have a threshold voltage equal to or more than the voltage VM and less than the voltage VH and set in the program state, if the second program condition is used, the threshold voltage of the selected cell transistor MTsel may excessively rise. For this reason, a third program condition for raising the threshold voltage of the selected cell transistor MTsel smaller than the rise amount under the second program condition is used. The selected cell transistor MTsel to which the third program condition is applied, that is, which is determined to have a threshold voltage belonging to the range A3 may be referred to as a selected cell transistor MTsel3.

In a certain program loop, the selected cell transistor MTsel determined by the VH sense operation to have a threshold voltage equal to or more than the voltage VH is set in the program inhibition state by program in the next program loop. The selected cell transistor MTsel having a threshold voltage determined to belong to the range A4 may be referred to as a selected cell transistor MTsel4.

In this way, the program condition different based on the four ranges of the threshold voltage of the selected cell transistor MTsel is used, thereby suppressing spread of the threshold voltage distribution after program.

In the first embodiment, the difference of the degree of lowering of the potential of the node SEN based on the threshold voltage of the selected cell transistor MTsel is used.

FIG. 13 illustrates the electric characteristic of a cell transistor of the memory device of the first embodiment. In FIG. 13, the ordinate indicates a current (drain current Ids) flowing via the cell transistor MT, and the abscissa indicates a voltage Vgs between the gate and the source of the cell transistor MT. If the voltage Vgs exceeds a threshold voltage Vth of the cell transistor, the drain current Ids sharply increases.

On the other hand, even if a voltage of the same magnitude is applied to the selected cell transistor MTsel, the higher the threshold voltage of the selected cell transistor MTsel is, the smaller the effective voltage Vgs is. Hence, even if a voltage of the same magnitude is applied to the selected cell transistor MTsel, the drain current Ids differs. More specifically, assume that a drain current Ids1 flows through the selected cell transistor MTsel1, a drain current Ids2 flows through the selected cell transistor MTsel2, a drain current Ids3 flows through the selected cell transistor MTsel3, and a drain current Ids4 flows through the selected cell transistor MTsel4. Then, Ids4 < Ids3 < Ids2 < Ids1 holds.

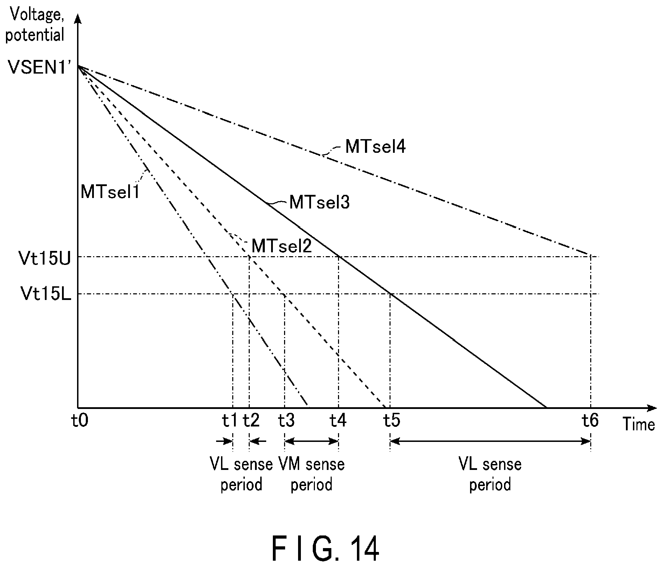

FIG. 14 illustrates, along time, the potential of a certain node based on the threshold voltage of the selected cell transistor during verification. FIG. 14 illustrates the potential of the node SEN in a state in which a predetermined voltage (for example, the verification voltage Vp of the target state) is applied to the selected word line WLsel, and illustrates the potential of the node SEN coupled to the selected cell transistors MTsel1, MTsel2, MTsel3, or MTsel4. Also, FIG. 14 illustrates a case where the potential of the node SEN lowers from a potential VSEN1' (VSEN1 + VCK1) commonly in a case of the selected cell transistors MTsel1, MTsel2, MTsel3, or MTsel4. A threshold voltage Vt15U is a maximum voltage that the threshold voltage of the transistor T15 of the sense amplifier circuit SAC can have. A threshold voltage Vt15L is a minimum voltage that the threshold voltage of the transistor T15 of the sense amplifier circuit SAC can have. That is, the transistor T15 can have a threshold voltage that varies due to the limitations of the manufacturing technique and can have a threshold voltage equal to or more than the threshold voltage Vt15L and equal to or less than the threshold voltage Vt15U.

As described with reference to FIG. 13, the lower the threshold voltage of the selected cell transistor MTsel is, the larger the drain current of the selected cell transistor MTsel is. Hence, as illustrated in FIG. 14, the lower the threshold voltage of the selected cell transistor MTsel is, the larger the lowering amount of the potential of the node SEN until a predetermined time elapses from the start (time t0) of potential lowering is. The VL sense operation, the VM sense operation, and the VH sense operation can be performed using this phenomenon.

After time t1, the potential of the node SEN coupled to the selected cell transistor MTsel1 is equal to or less than the threshold voltage Vt15L. On the other hand, until time t2, the potential of the node SEN coupled to the selected cell transistor MTsel2, MTsel3, or MTsel4 is equal to or more than the threshold voltage Vt15U. Hence, by the sense operation between time t1 and time t2, it is possible to determine whether the selected cell transistor MTsel is the selected cell transistor MTsel1 or the selected cell transistor MTsel2, MTsel3, or MTsel4. That is, the transistor T15 coupled to the selected cell transistor MTsel having a low threshold voltage is ON and, therefore, the selected cell transistor MTsel coupled to the transistor T15 that is ON at an early stage from the start of lowering of the potential of the node SEN can be determined to have a low threshold voltage. The selected cell transistor MTsel determined to be ON from time t1 to time t2 can be determined to have a threshold voltage belonging to the range A1, that is, be the selected cell transistor MTsel1.

On the other hand, from time t1 to time t2, the transistor T15 coupled to the selected cell transistor MTsel having a relatively low, relatively high, or high threshold voltage remains OFF. Hence, the selected cell transistor MTsel coupled to the transistor T15 that remains OFF even after the early stage from the start of lowering of the potential of the node SEN can be determined to have a relatively low, relatively high, or high threshold voltage. The selected cell transistor MTsel that is OFF from time t1 to time t2 can be determined to have a threshold voltage belonging to the range A2, A3, or A4, that is, be the selected cell transistor MTsel2, MTsel3, or MTsel4.

Determining, by the sense operation between time t1 and time t2, whether the threshold voltage of the selected cell transistor MTsel belongs to the range A1 or the range A2, A3, or A4 is equivalent to executing the VL sense operation.

From time t3, the potential of the node SEN coupled to the selected cell transistor MTsel1 or MTsel2 is equal to or less than the threshold voltage Vt15L. On the other hand, until time t4, the potential of the node SEN coupled to the selected cell transistor MTsel3 or MTsel4 is equal to or more than the threshold voltage Vt15U. Hence, by the sense operation between time t3 and time t4, it is possible to determine whether the selected cell transistor MTsel is the selected cell transistor MTsel1 or MTsel2 or the selected cell transistor MTsel3 or MTsel4. That is, the transistor T15 coupled to the selected cell transistor MTsel having a low or relatively low threshold voltage is ON and, therefore, the selected cell transistor MTsel coupled to the transistor T15 that is ON at a relatively early stage from the start of lowering of the potential of the node SEN can be determined to have a threshold voltage belonging to the range A2, that is, be the selected cell transistor MTsel1 or MTsel2.

On the other hand, from time t3 to time t4, the transistor T15 coupled to the selected cell transistor MTsel having a relatively high or high threshold voltage remains OFF. Hence, the selected cell transistor MTsel coupled to the transistor T15 that remains OFF even after the early stage from the start of lowering of the potential VSEN can be determined to have a relatively high or high threshold voltage. The selected cell transistor MTsel that is OFF from time t3 to time t4 can be determined to have a threshold voltage belonging to the range A3 or A4, that is, be the selected cell transistor MTsel2 or MTsel3.

Determining, by the sense operation between time t3 and time t4, whether the threshold voltage of the selected cell transistor MTsel belongs to the range A1 or A2 or the range A3 or A4 is equivalent to executing the VM sense operation.

After time t5, the potential of the node SEN coupled to the selected cell transistor MTsel1, MTsel2, or MTsel3 is equal to or less than the threshold voltage Vt15L. On the other hand, until time t6, the potential of the node SEN coupled to the selected cell transistor MTsel4 is equal to or more than the threshold voltage Vt15U. Hence, by the sense operation between time t5 and time t6, it is possible to determine whether the selected cell transistor MTsel is the selected cell transistor MTsel1, MTsel2, or MTsel3, or the selected cell transistor MTsel4. That is, the transistor T15 coupled to the selected cell transistor MTsel having a low, relatively low, or relatively high threshold voltage is ON and, therefore, the selected cell transistor MTsel coupled to the transistor T15 that is ON at a relatively late stage from the start of lowering of the potential of the node SEN can be determined to have a low, relatively low, or relatively high threshold voltage. The selected cell transistor MTsel determined to be ON from time t5 to time t6 can be determined to have a threshold voltage belonging to the range A1, A2, or A3, that is, be the selected cell transistor MTsel1, MTsel2, or MTsel3.

On the other hand, from time t5 to time t6, the transistor T15 coupled to the selected cell transistor MTsel having a high threshold voltage remains OFF. Hence, the selected cell transistor MTsel coupled to the transistor T15 that remains OFF even after the relatively late stage from the start of lowering of the potential of the node SEN can be determined to have a high threshold voltage. The selected cell transistor MTsel that is OFF from time t5 to time t6 can be determined to have a threshold voltage belonging to the range A4, that is, be the selected cell transistor MTsel4.

Determining, by the sense operation between time t5 and time t6, whether the threshold voltage of the selected cell transistor MTsel belongs to the range A1, A2, or A3 or belongs to the range A4 is equivalent to executing the VH sense operation.

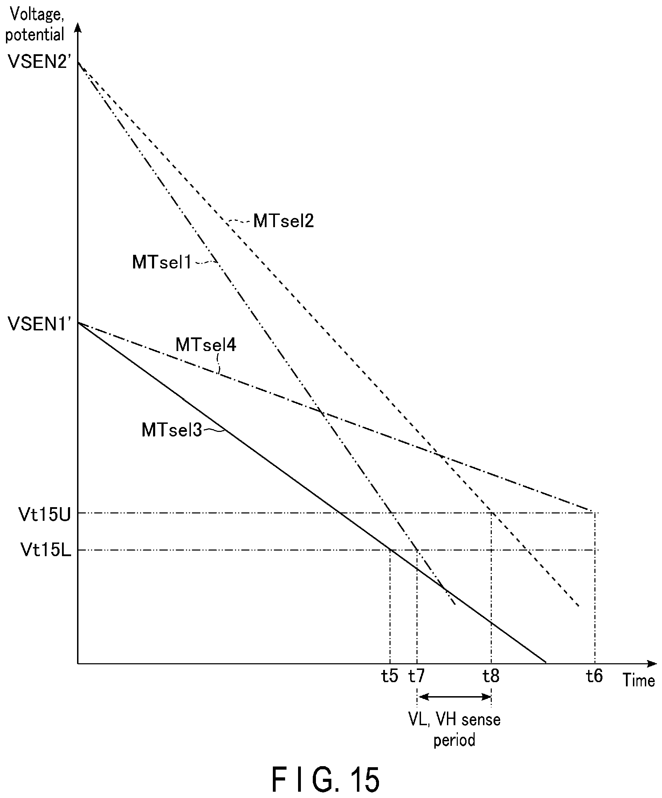

The method described with reference to FIG. 14 requires three sense operations. To suppress the count, the memory device 1 performs the VM sense operation first, and then performs a sense operation corresponding to one of the VL sense operation and the VH sense operation corresponding to the result of the VM sense operation. The outline of the operation of the memory device 1 of the first embodiment will be described below with reference to FIG. 15. FIG. 15 illustrates the concept of verification in the memory device of the first embodiment. More specifically, FIG. 15 illustrates, along time, the potential of the node SEN during a certain sense operation in the memory device 1.

As illustrated in FIG. 15, the lowering speeds (or the gradients) of the potentials of the nodes SEN coupled to the selected cell transistors MTsel1, MTsel2, MTsel3, and MTsel4 are the same as in the case illustrated in FIG. 14. The node SEN coupled to the selected cell transistor MTsel3 or MTsel4 has the potential VSEN1' (VSEN1 + VCK1) at the start of the sense operation (VM sense operation). On the other hand, the node SEN coupled to the selected cell transistor MTsel1 or MTsel2 has a potential VSEN2' (VSEN2 + VCK1) at the start of the same sense operation. The potential VSEN2 is higher than the potential VSEN1. In addition, the potential VSEN2' is higher than the potential VSEN1'. The potential VSEN2 is determined such that the following conditions are satisfied. That is, when the potential VSEN2' (VSEN2) is used, the positions of lines indicating the potentials of the node SEN in a case of the selected cell transistors MTsel1 and MTsel2 change. The potential VSEN2' (VSEN2) by the changed position is determined such that a period is generated in which the potential of each of the nodes SEN coupled to the selected cell transistors MTsel1 and MTsel3 is less than the threshold voltage Vt15U and the potential of each of the nodes SEN coupled to the selected cell transistors MTsel2 and MTsel4 is equal to or more than the threshold voltage Vt15U. In the example illustrated in FIG. 15, the period is from time t7 to time t8. Time t7 comes after time t5, and time t8 comes after time t7 and before time t6.

According to the example illustrated in FIG. 15, from time t5, the potential of the node SEN coupled to the selected cell transistor MTsel3 is less than the threshold voltage Vt15L. Until time t6, the potential of the node SEN coupled to the selected cell transistor MTsel4 is equal to or more than the threshold voltage Vt15U. Hence, it is possible to determine, by the sense operation between time t5 and time t6, whether the selected cell transistor MTsel is the selected cell transistor MTsel3 or the selected cell transistor MTsel4.

After time t7, the potential of the node SEN coupled to the selected cell transistor MTsel1 is less than the threshold voltage Vt15L. Until time t8, the potential of the node SEN coupled to the selected cell transistor MTsel2 is equal to or more than the threshold voltage Vt15U. Hence, it is possible to determine, by the sense operation between time t7 and time t8, whether the selected cell transistor MTsel is the selected cell transistor MTsel1 or the selected cell transistor MTsel2.

That is, by the sense operation between time t7 and time t8, it is possible to parallelly determine whether the selected cell transistor MTsel having a threshold voltage less than the threshold voltage VM is the selected cell transistor MTsel1 or MTsel2 (equivalent to the VL sense operation) and determine whether the selected cell transistor MTsel having a threshold voltage equal to or more than the threshold voltage VM is the selected cell transistor MTsel3 or MTsel4 (equivalent to the VH sense operation).

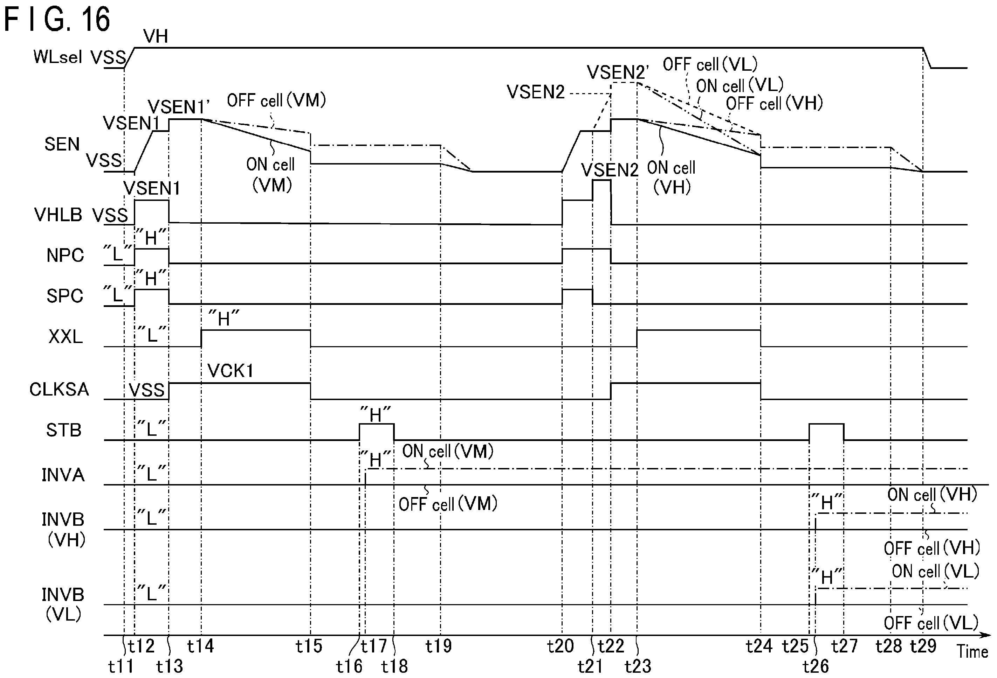

FIG. 16 illustrates, along time, the potentials of several nodes and signals during verification of the memory device of the first embodiment.

At the start of the period illustrated in FIG. 16, the nodes and the signals have the following potentials or levels. The selected word line WLsel, the node VHLB, and the node CLKSA have the potential VSS. The signals NPC, SPC, XXL, and STB have a low ("L") level. The nodes INVA and INVB have a low level, that is, the latch circuits ADL and BDL hold "0" data.

The transistor T10 is OFF because of the signal NPC of the low level, and the node CLKSA has the potential VSS. Hence, the node SEN has the potential VSS. The potential VSS has the same magnitude as the ground voltage VSS.

At time t11, the potential of the selected word line WLsel is set to the potential VH. The potential VH has the same magnitude as the voltage VH and depends on the state targeted by verification in which the waveform illustrated in FIG. 16 is occurs. In an example, if the target state is "S2 state", the potential VH has a magnitude of the voltage Vp2.

At time t12, the potential of the node VHLB is set to the potential VSEN1. At time t12, the signals NPC and SPC are set to a high ("H") level. Hence, the potential of the node VHLB is applied to the node SEN via the transistors T9 and T10 that are ON, and the node SEN has the potential VSEN1.

At time t13, the potential of the node VHLB is set to the potential VSS, and the signals NPC and SPC are set to the low level. Hence, application of the voltage from the node VHLB to the node SEN stops.

At time t13, the potential of the node CLKSA is set to a potential VCK1. Hence, the potential of the node SEN rises as much as the magnitude of the potential VCK1 by coupling of the capacitor P1. More specifically, the potential of the node SEN rises from the potential VSEN1 to the potential VSEN1'.

At time t14, the signal XXL is set to the high level. The transistor T5 is thus turned on. Although not illustrated, the signals BLS and BLC are also set to the high level. The transistors T3 and T4 are thus turned on. The node SEN is coupled to a single bit line BL via the transistors T3, T4, and T5, which are in the ON state. Hence, the potential of the node SEN lowers at a speed based on the threshold voltage of the selected cell transistor MTsel coupled via the bit line BL.

If the node SEN is coupled to the selected cell transistor MTsel in the OFF state, the potential of the node SEN lowers slowly, as indicated by a one-dot dashed line. The selected cell transistor MTsel that is OFF may be referred to as an OFF cell hereinafter.

On the other hand, if the node SEN is coupled to the selected cell transistor MTsel that is ON, the potential of the node SEN lowers sharply, as indicated by a solid line. The selected cell transistor MTsel that is ON may be referred to as an ON cell hereinafter.

At time t15, the potential of the node CLKSA is set to the potential VSS. The potential of the node SEN thus lowers as much as the magnitude of the potential VCK1.

At time t15, the signal XXL is set to the low level. The node SEN is thus decoupled from the bit line BL and electrically floats. Hence, the lowering of the potential of the node SEN from time t14 stops, and the potential of the node SEN at time t15 is stored in the node SEN. The high level period of the signal XXL defines the time in which the lowering of the potential of the node SEN continues.

At time t16, the signal STB is set to the high level. The first sense operation is thus started. At time t17, when the signal ATI (not shown) is set to the high level, the sense amplifier circuit SAC may sense, sample, obtain, or acquire data by transferring data based on or indicated by the potential of the node SEN to the latch circuit ADL and storing the transferred data by the latch circuit ADL. That is, the node INVA has a level based on the potential of the node SEN. In one aspect, the data based on or indicated by the potential of the node SEN corresponds to data stored by a memory cell. For example, if the node SEN is coupled to an OFF cell, the node INVA has the low level. If the node SEN is coupled to an ON cell, the node INVA has the high level. Hence, the data in the latch circuit ADL indicates the result of the VM sense operation.

At time t18, the signal STB is set to the low level. The first sense operation is thus ended. At time t18, when the signal ATI (not shown) is set to the low level, transfer of the data based on the potential of the node SEN to the latch circuit ADL is ended. The first sense operation between time t16 and time t18 corresponds to the VM sense operation.

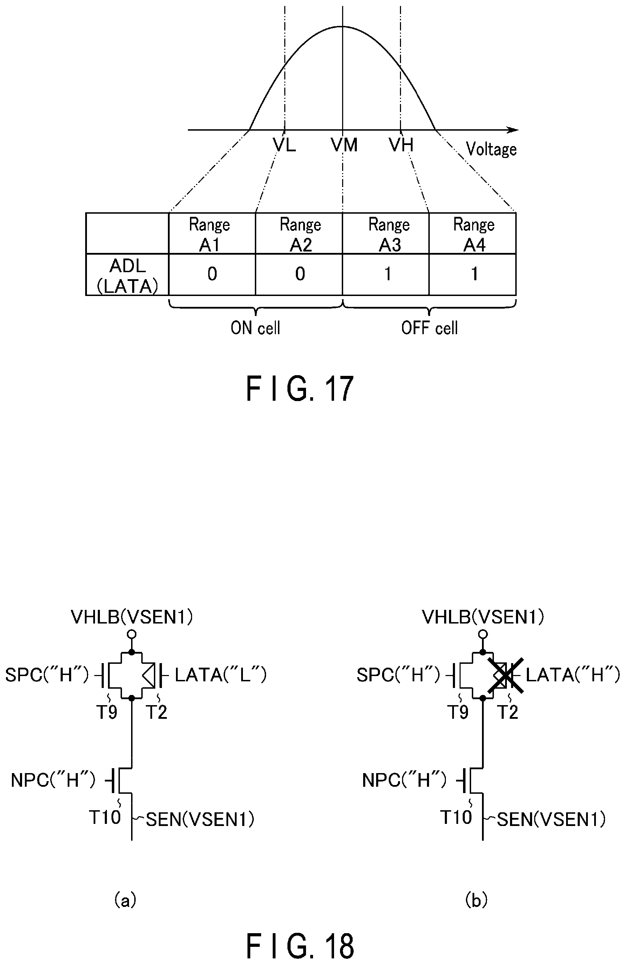

FIG. 17 illustrates an example of data in a latch circuit during verification of the memory device of the first embodiment. More specifically, FIG. 17 illustrates data stored in the latch circuit ADL at time t18 (or, at the end of the VM sense operation). As illustrated in FIG. 17, the latch circuit ADL that stores data based on the node SEN coupled to an ON cell stores "0" data (or, low level). The selected cell transistor MTsel coupled to the latch circuit ADL that stores "0" data is determined to have a threshold voltage belonging to the range A1 or A2.

On the other hand, the latch circuit ADL that stores data based on the node SEN coupled to an OFF cell stores "1" data (or, high level). The selected cell transistor MTsel coupled to the latch circuit ADL that stores "1" data is determined to have a threshold voltage belonging to the range A3 or A4.

Referring back to FIG. 16, at time t19, the node SEN is set to the potential VSS.

At time t20, the node VHLB is set to the potential VSEN1, and the signals NPC and SPC are set to the high level. The state of a part of the sense amplifier circuit SAC at this time is illustrated in FIG. 18. FIG. 18 illustrates a state of a part of the sense amplifier circuit of the memory device of the first embodiment. As indicated by a portion (a) in FIG. 18, if the node LATA of the sense amplifier circuit SAC has low level based on the result of the VM sense operation, the transistor T2 is ON. Hence, a current path via the transistor T2 is formed between the node VHLB and the transistor T10. On the other hand, as indicated by a portion (b) in FIG. 18, if the node LATA of the sense amplifier circuit SAC has the high level based on the result of the VM sense operation, the transistor T2 is OFF. Hence, the current path via the transistor T2 is not formed between the node VHLB and the transistor T10. However, the transistor T9 is ON by the signal SPC of the high level. Hence, a current path via the transistor T9 is not formed between the node VHLB and the transistor T10. Hence, the node VHLB is coupled to the node SEN regardless of the result of the VM sense operation, that is, ON or OFF of the transistor T2. Hence, the node SEN has the potential VSEN1.

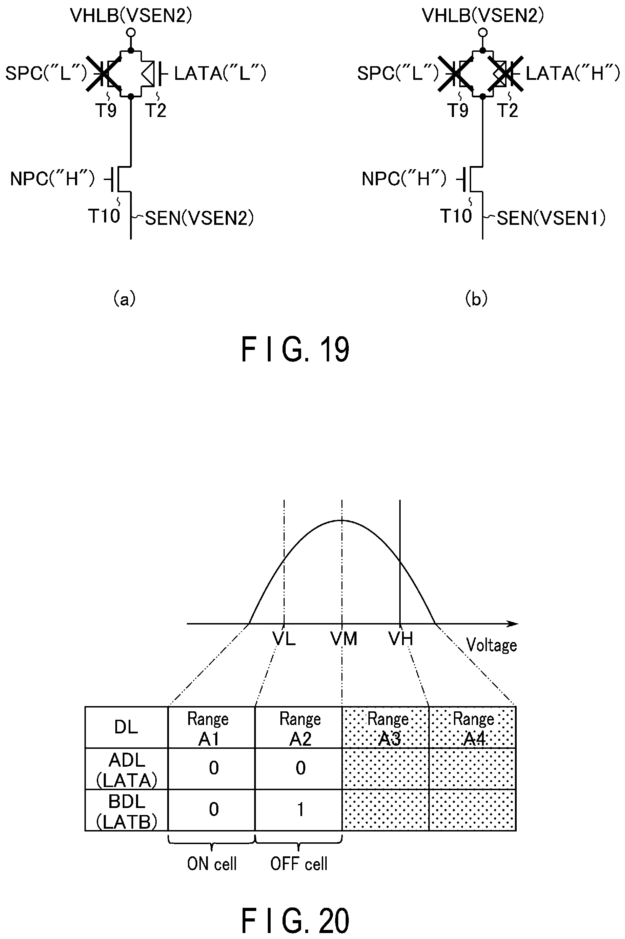

Referring back to FIG. 16, at time t21, the potential of the node SEN is set to the potential VSEN2, and the signal SPC is set to the low level. The state of a part of the sense amplifier circuit SAC at this time is illustrated in FIG. 19. FIG. 19 illustrates a state of a part of the sense amplifier circuit of the memory device of the first embodiment. As illustrated in FIG. 19, the transistor T9 is OFF by the signal SPC of the low level. Hence, the current path via the transistor T9 is not formed between the node VHLB and the transistor T10.

As indicated by a portion (a) in FIG. 19, if the node LATA of the sense amplifier circuit SAC has the low level based on the result of the VM sense operation, the transistor T2 is ON. Hence, the current path via the transistor T2 is formed between the node VHLB and the transistor T10. Hence, at time 22, the node SEN of the sense amplifier circuit SAC coupled to the OFF cell determined at time t17 has the potential VSEN2.

On the other hand, as indicated by a portion (b) in FIG. 19, if the node LATA of the sense amplifier circuit SAC has the high level based on the result of the VM sense operation, the transistor T2 is OFF. Hence, no current path is formed between the node VHLB and the transistor T10, and the potential of the node VHLB is not transferred to the node SEN. Hence, at time t22, the node SEN of the sense amplifier circuit SAC coupled to the ON cell determined at time t17 has the potential VSEN1.

Referring back to FIG. 16, at time t22, the potential of the node SEN is set to the potential VSS, and the signal NPC is set to the low level. Hence, application of the voltage from the node VHLB to the node SEN stops.

At time t22, the potential of the node CLKSA is set to the potential VCK1. Hence, the potential of the node SEN rises as much as the magnitude of the potential VCK1 by coupling of the capacitor P1. As a result, the potential of the node SEN of the sense amplifier circuit SAC coupled to the ON cell determined at time t17 is increased from the potential VSEN1 to the potential VSEN1' (VSEN1 + VCK1), and the potential of the node SEN of the sense amplifier circuit SAC coupled to the OFF cell determined at time t17 is increased from the potential VSEN2 to the potential VSEN2' (VSEN2 + VCK1).

At time t23, the signal XXL is set to the high level. The transistor T5 is thus turned on. Although not illustrated, the signals BLS and BLC are also set to the high level. The transistors T3 and T4 are thus turned on. The node SEN is coupled to a single bit line BL via the transistors T3, T4, and T5, which are ON. Hence, the potential of the node SEN lowers at a speed based on the threshold voltage of the selected cell transistor MTsel coupled via the bit line BL.

If the node SEN has the potential VSEN1' at time t23 and is coupled to an ON cell, the change of the potential of the node SEN is the same as the change from time t14, as indicated by a solid line. If the node SEN has the potential VSEN1' at time t23 and is coupled to an OFF cell, the change of the potential of the node SEN is the same as the change from time t14, as indicated by a one-dot dashed line.

If the node SEN has the potential VSEN2' at time t23 and is coupled to an ON cell, the potential of the node SEN lowers slowly, as indicated by a broken line. If the node SEN has the potential VSEN2' at time t23 and is coupled to an OFF cell, the potential of the node SEN lowers sharply, as indicated by a two-dot dashed line.

To prevent the drawing from being complex more than necessity, FIG. 16 illustrates that at time t24, the potential of the node SEN having the potential VSEN1' at time t23 and coupled to an ON cell is the same as the potential of the node SEN having the potential VSEN2' at time t23 and coupled to an ON cell. Similarly, FIG. 16 illustrates that at time t24, the potential of the node SEN having the potential VSEN1' at time t23 and coupled to an OFF cell is the same as the potential of the node SEN having the potential VSEN2' at time t23 and coupled to an OFF cell.

At time t24, the potential of the node CLKSA is set to the potential VSS. The potential of the node SEN thus lowers as much as the magnitude of the potential VCK1.

At time t24, the signal XXL is set to the low level. The node SEN is thus decoupled from the bit line BL and electrically floats. Hence, the lowering of the potential of the node SEN from time t23 stops, and the potential of the node SEN at time t24 is stored in the node SEN. The signal XXL maintains the high level from time t22 to time t24. The high level period of the signal XXL defines the time in which the lowering of the potential of the node SEN continues. Based on the example illustrated in FIG. 16, the high level period (from time t23 to time t24) of the signal XXL for the second sense operation is longer than the high level period (from time t14 to time t15) of the signal XXL for the first sense operation.

At time t25, the signal STB is set to the high level. The second sense operation is thus started. At time t26, when the signal BTI (not shown) is set to the high level, the sense amplifier circuit SAC may sense, sample, obtain, or acquire data by transferring data based on or indicated by the potential of the node SEN to the latch circuit BDL and storing the transferred data by the latch circuit BDL. That is, the node INVB has a level based on the potential of the node SEN. In one aspect, the data based on or indicated by the potential of the node SEN corresponds to data stored by a memory cell. For example, if the node SEN is coupled to an OFF cell, the node INVB has the low level. If the node SEN is coupled to an ON cell, the node INVB has the high level.

At time t27, the signal STB is set to the low level. The second sense operation is thus ended. At time t27, when the signal BTI (not shown) is set to the low level, transfer of the data based on the potential of the node SEN to the latch circuit ADL is ended. The second sense operation between time t25 and time t27 corresponds to the VL sense operation and the VH sense operation.

FIG. 20 illustrates an example of data in a latch circuit during verification of the memory device of the first embodiment. More specifically, FIG. 20 illustrates data stored in the latch circuit BDL at time t27 (at the end of the VL sense operation and the VH sense operation). FIG. 20 illustrates a case of ON cell in the VM sense operation, that is, a case where the latch circuit ADL stores "0" data. As illustrated in FIG. 20, the latch circuit BDL that stores data based on the node SEN coupled to an ON cell stores "0" data. The selected cell transistor MTsel coupled to the node SEN that causes the latch circuit BDL to store "0" data is determined to have a threshold voltage belonging to the range A1.

On the other hand, the latch circuit BDL that stores data based on the node SEN coupled to an OFF cell stores "1" data. The selected cell transistor MTsel coupled to the node SEN that causes the latch circuit BDL to store "1" data is determined to have a threshold voltage belonging to the range A2.

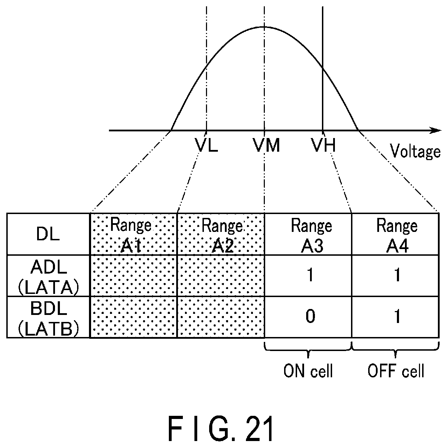

FIG. 21 illustrates an example of data in a latch circuit during verification of the memory device of the first embodiment. More specifically, FIG. 21 illustrates data stored in the latch circuit BDL at time t27 (at the end of the VL sense operation and the VH sense operation). FIG. 21 illustrates a case of OFF cell in the VM sense operation, that is, a case where the latch circuit ADL stores "1" data. As illustrated in FIG. 21, the latch circuit BDL that stores data based on the node SEN coupled to an ON cell stores "0" data. The selected cell transistor MTsel coupled to the node SEN that causes the latch circuit BDL to store "0" data is determined to have a threshold voltage belonging to the range A3.

On the other hand, the latch circuit BDL that stores data based on the node SEN coupled to an OFF cell stores "1" data. The selected cell transistor MTsel coupled to the node SEN that causes the latch circuit BDL to store "1" data is determined to have a threshold voltage belonging to the range A4.

Referring back to FIG. 16, at time t28, the ground voltage VSS is applied to the node SEN. At time t29, the potential of the selected word line WLsel is set to the potential VSS.

### 1.3. Advantages (Advantageous Effects)

According to the first embodiment, the memory device 1 can operate at a high speed, as will be described below.

The memory device 1 performs the VM sense operation for each of a plurality of selected cell transistors MTsel during application of the verification voltage VH (Vp) based on a target state to the selected word line WLsel. By the VM sense operation, information indicating whether the selected cell transistor MTsel has a threshold voltage less than or equal to or more than the voltage based on the target state, that is, information indicating whether the selected cell transistor MTsel belongs to the range A1 or A2 or the range A3 or A4. To the node SEN coupled to the selected cell transistor MTsel determined to belong to the range A1 or A2, the memory device 1 applies a voltage higher than a voltage applied to the node SEN coupled to the selected cell transistor MTsel determined to belong to the range A3 or A4. This generates a period in which the potential of the node SEN of the selected cell transistor MTsel determined to belong to the range A1 or A2 and the potential of the node SEN of the selected cell transistor MTsel determined to belong to the range A3 or A4 overlap. The sense operation is performed during the overlap period. The sense operation performed, during the overlap period, for the selected cell transistor MTsel determined to belong to the range A1 or A2 corresponds to the VL sense operation. The sense operation performed, during the overlap period, for the selected cell transistor MTsel determined to belong to the range A3 or A4 corresponds to the VH sense operation. It is therefore possible to perform the VL sense operation and the VH sense operation in parallel. Hence, the VL sense operation, the VM sense operation, and the VH sense operation are completed in two sense periods. For this reason, verification can be completed in a short period, that is, a high-speed operation can be performed.

### 1.4. Modification

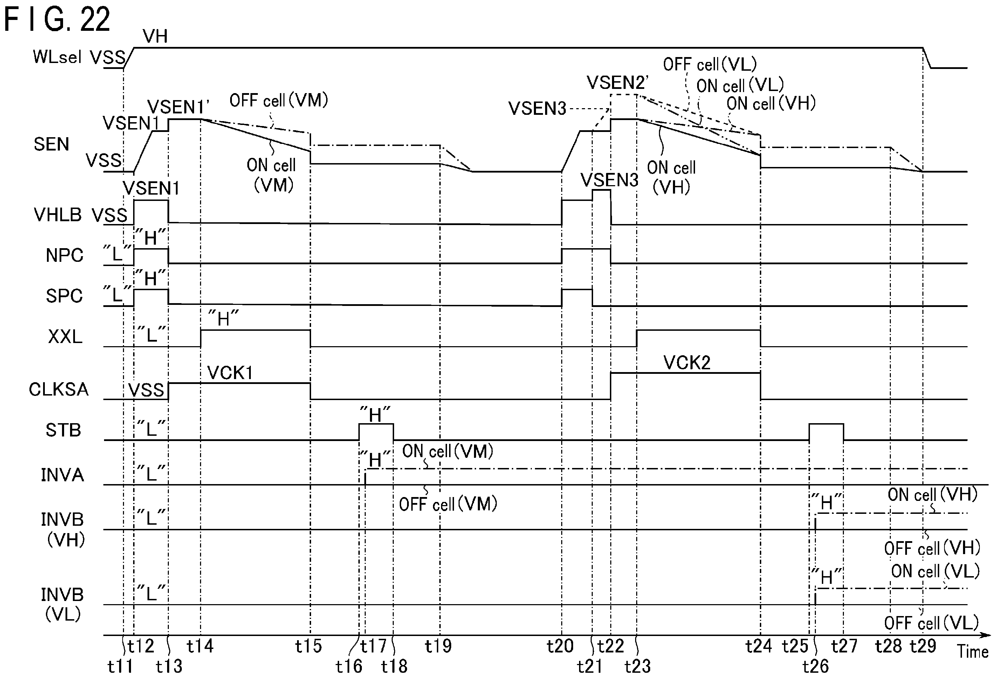

FIG. 22 illustrates, along time, the potentials of several nodes and signals during verification of a memory device of a modification of the first embodiment.

As illustrated in FIG. 22, the potential of the node SEN may be raised from the potential VSEN3 to the potential VSEN2' by raising the potential of the node CLKSA. That is, from time t22 to time t24, the potential of the node VHLB is set to a potential VSEN3. On the other hand, the operation of the node CLKSA is set to a potential VCK2. The potential VSEN3 is lower than the potential VSEN2 in Fig. 16. The potential VCK2 is higher than the potential VCK1. The low potential of the node VHLB is thus compensated for by the potential of the node CLKSA so that the potential of the node SEN rises from the potential VSEN3 to the potential VSEN2' (VSEN3 + VCK2).

### 2. Second Embodiment

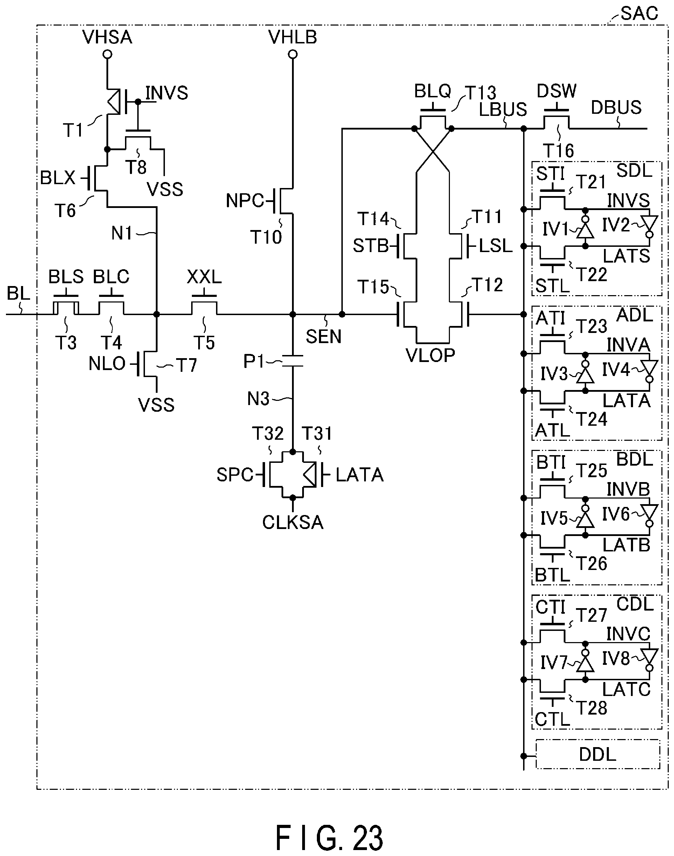

FIG. 23 illustrates a circuit diagram of a sense amplifier circuit of a memory device of a second embodiment. As illustrated in FIG. 23, a sense amplifier circuit SAC does not include transistors T2 and T9 but include transistors T31 and T32.

A transistor T10 is coupled between a node VHLB and a node SEN. The transistors T31 and T32 are coupled in parallel between a node CLKSA and a node N3. A capacitor P1 is coupled between the node SEN and the node N3.

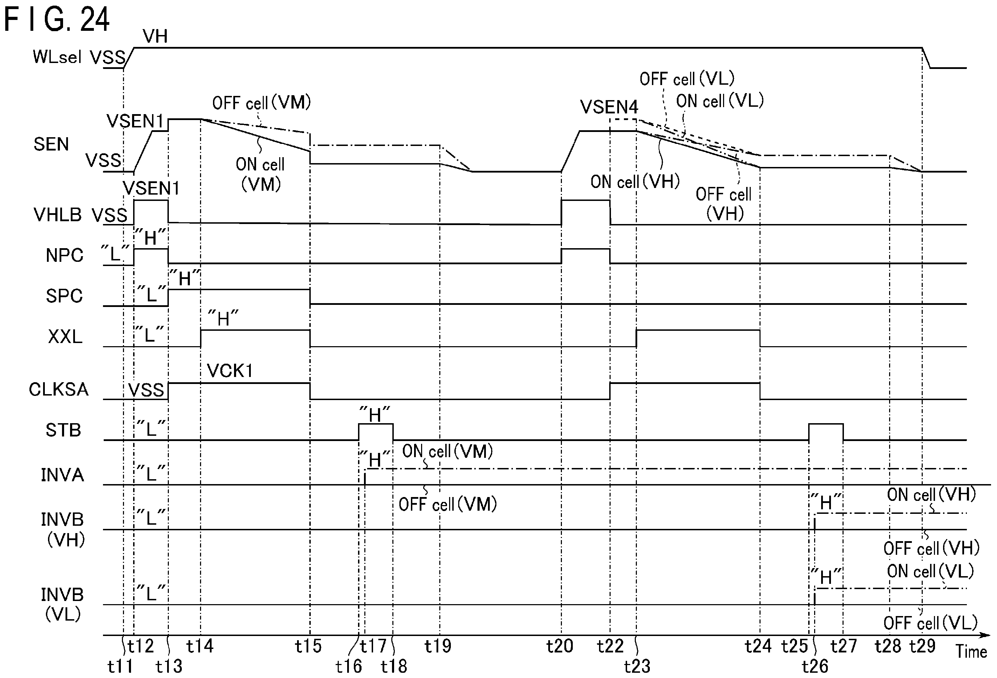

FIG. 24 illustrates, along time, the potentials of several nodes and signals during verification of the memory device of the second embodiment.

As illustrated in FIG. 24, a signal SPC has a high level from time t13 to time t15. Hence, a current path is formed between the node CLKSA and the capacitor P1, and the potential of the node SEN rises as the potential of the node CLKSA rises.

After time t20, the operation at time t21 in the first embodiment does not occur. That is, from time t20 to time t22, the potential of the node VHLB is set to a potential VSEN1.

The signal SPC has a low level from time t22 to time t24. Hence, the transistor T32 is OFF, and a current path via the transistor T32 is not formed between the node CLKSA and the node N3.

As in the first embodiment, at time t22, the potential of the node CLKSA is set to the potential VCK1. A node INVA of the sense amplifier circuit SAC coupled to an OFF cell from time t14 to time t15 has the low level. Hence, a node LATA has the high level, and at time t22, the transistor T31 of the sense amplifier circuit SAC coupled to the OFF cell is OFF. Hence, no current path is formed between the node CLKSA and a node N2. Hence, the potential of the node SEN coupled to the OFF cell in a VM sense operation does not rise at time t22.

On the other hand, the node INVA of the sense amplifier circuit SAC coupled to an ON cell from time t14 to time t15 has the high level. Hence, the node LATA has the low level, and, therefore, the transistor T31 of the sense amplifier circuit SAC coupled to the ON cell is ON at time t22. Hence, a current path is formed between the node CLKSA and the node N2. Hence, the potential of the node SEN coupled to the ON cell in the VM sense operation rises to a potential VSEN4 at time t22.

As described above, at time t22, the potential of the node SEN coupled to an OFF cell in the VM sense operation rises, and the potential of the node SEN coupled to an ON cell in the VM sense operation does not rise. Hence, as in the first embodiment, the VL sense operation and the VM sense operation can be performed from time t23 to time t24 in parallel.

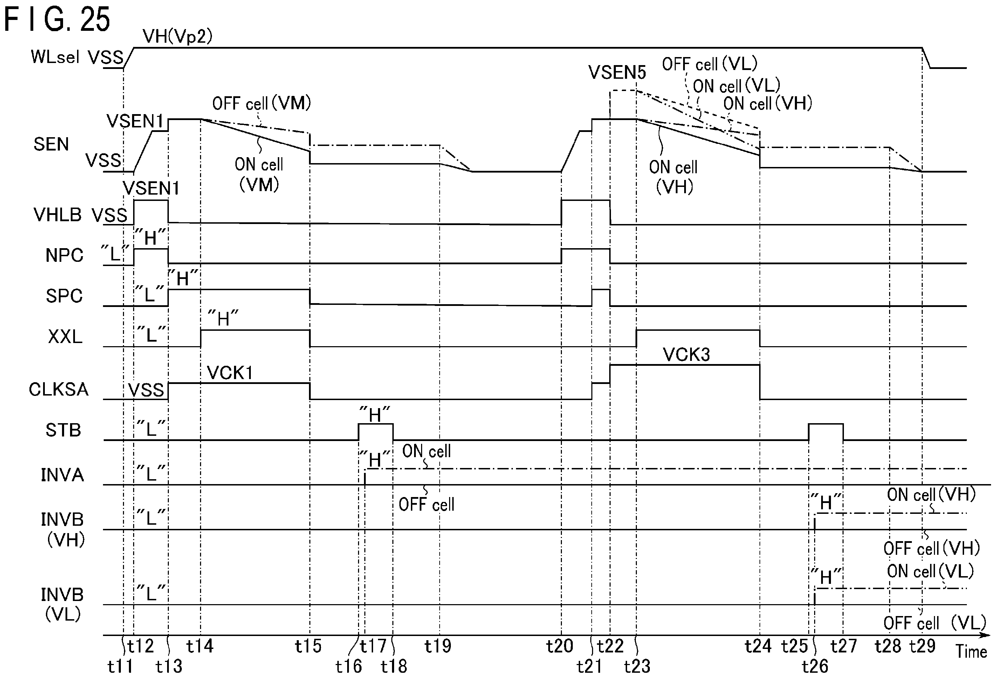

The potential rise of the node SEN caused by potential rise of the node CLKSA at time t22 and control of the potential rise or non-rise of the node SEN may be used together. FIG. 25 illustrates, along time, the potentials of several nodes and signals during verification of a modification of the second embodiment.

As illustrated in FIG. 25, from time t21 to time t22, the signal SPC is set to the high level. The transistor T32 is thus ON, and the node CLKSA is coupled to the capacitor P1 via the transistor T32 that is ON.

At time t21, the potential of the node CLKSA is set to the potential VCK1. Hence, the potential of the node SEN rises to the potential VSEN1 without depending on the result of the VM sense operation.

At time t22, the signal SPC is set to low level. The current path via the transistor T32 between the node CLKSA and the capacitor P1 thus disappears.

At time t22, the potential of the node CLKSA is set to a potential VCK3. The potential VCK3 is higher than the potential VCK1. The node INVA of the sense amplifier circuit SAC coupled to an OFF cell in the VM sense operation has low level. Hence, the node LATA has high level, and, therefore, the transistor T31 of the sense amplifier circuit SAC coupled to the OFF cell is OFF at time t22. Hence, no current path is formed between the node CLKSA and the node N3. Hence, the potential of the node SEN coupled to the OFF cell in the VM sense operation does not rise at time t22.

On the other hand, the node INVA of the sense amplifier circuit SAC coupled to an ON cell in the VM sense operation has high level. Hence, the node LATA has low level, and, therefore, the transistor T31 of the sense amplifier circuit SAC coupled to the ON cell is ON at time t22. Hence, a current path is formed between the node CLKSA and the node N3. Hence, the potential of the node SEN coupled to the ON cell in the VM sense operation rises to a potential VSEN5 at time t22. The potential VSEN5 is higher than the potential VSEN1.

According to the second embodiment, as in the first embodiment, the potential of the node SEN coupled to a selected cell transistor MTsel determined to belong to a range A1 or A2 based on the result of the VM sense operation is raised. It is therefore possible to cause the period of sense of the selected cell transistor MTsel determined to belong to the range A1 or A2 to overlap the period of sense of the selected cell transistor MTsel determined to belong to a range A3 or A4. Hence, the same advantages as in the first embodiment can be obtained.

### 3. Modification

In the first embodiment, the capacitor P1 may be absent. In this case, raise of the potential of the node SEN at time t13 and time t22 and lowering of the potential of the node SEN at time t15 and time t24 are not performed.

Various embodiments disclosed herein are related to a memory device. In some embodiments, the memory device includes a memory cell, a word line coupled to the memory cell, and a bit line coupled to the memory cell. In some embodiments, the memory device includes a first transistor having a gate coupled to a first node, which is coupled to the bit line. The first transistor may be coupled to a second node. In some embodiments, the memory device includes a first latch circuit coupled to the second node. The first latch circuit may include a third node. In some embodiments, the memory device includes a second transistor coupled between the first node and a fourth node. A gate of the second transistor may be coupled to a node different from the third node. In some embodiments, the memory device includes a third transistor coupled between the first node and the fourth node. A gate of the third transistor may be coupled to the third node.

In some embodiments, the second transistor and the third transistor are coupled in parallel with each other between the first node and the fourth node.

In some embodiments, the first latch circuit includes a first inverter circuit having an input coupled to the third node, and an output coupled to a fifth node. In some embodiments, the first latch circuit includes a second inverter circuit having an input coupled to the fifth node, and an output coupled to the third node.

In some embodiments, the first node is configured to receive a dynamically selected one of a first voltage or a second voltage higher than the first voltage.

In some embodiments, the memory device includes a fourth transistor coupled between the first transistor and the second node.

In some embodiments, the memory device includes a fifth transistor coupled to the second transistor in series between the first node and the fourth node.

In some embodiments, the memory device includes a capacitor coupled to the first node.

In some embodiments, the memory device includes a second latch circuit coupled to the second node. Throughout a first period, a first voltage may be applied to the word line. The first period may include a second period, a third period after the second period, and a fourth period after the third period. In the second period, the first latch circuit may be configured to store first data corresponding to the potential of the first node. In the third period, either one of a second voltage or a third voltage higher than the second voltage may be applied to the first node, according to the first data. In the fourth period, the second latch circuit may be configured to store second data corresponding to the potential of the first node changed from the one of the second voltage or the third voltage applied.

In some embodiments, in the third period, the second voltage may be applied to the first node, according to the first data being a first value. In some embodiments, in the third period, the third voltage is applied to the first node, according to the first data being a second value.

Various embodiments disclosed herein are related to a memory device. In some embodiments, the memory device includes a memory cell, a word line coupled to the memory cell, and a bit line coupled to the memory cell. In some embodiments, the memory device includes a sense amplifier circuit coupled to the bit line. The sense amplifier circuit may include a first node. The sense amplifier circuit may be configured to acquire data based on a potential of the first node. In some embodiments, a first voltage is applied to the word line throughout a first period. In some embodiments, the first period includes a second period, a third period after the second period, and a fourth period after the third period. In some embodiments, the sense amplifier circuit is configured to acquire first data based on the potential of the first node in the second period. In some embodiments, the sense amplifier circuit is configured to apply either one of a second voltage or a third voltage higher than the second voltage to the first node in the third period, based on the first data. In some embodiments, the sense amplifier circuit is configured to acquire second data in the fourth period, based on the potential of the first node changed from the one of the second voltage or the third voltage applied.

In some embodiments, the sense amplifier circuit is configured to apply the second voltage to the first node prior to applying the third voltage in the third period.

In some embodiments, the sense amplifier circuit is configured to apply, the second voltage to the first node in the third period, in response to the first data corresponding to the memory cell turned on during the second period. In some embodiments, the sense amplifier circuit is configured to apply, the third voltage to the first node in the third period, in response to the first data corresponding to the memory cell turned off during the second period.

In some embodiments, the memory device includes a first transistor coupled between the bit line and the first node. The first transistor may be turned on throughout a fifth period within the second period, and turned on throughout a sixth period within the fourth period. The sixth period may be longer than the fifth period.

In some embodiments, the memory device includes a second transistor having a gate coupled to the first node. In some embodiments, the memory device includes a first latch circuit configured to store the first data. In some embodiments, the memory device includes a third transistor coupled between the second transistor and the first latch circuit. The first period may include a seventh period between the fifth period and the third period, and an eighth period after the sixth period. The third transistor may be turned on in each of the seventh period and the eighth period. The third transistor may be turned off in a time period between the seventh period and the eighth period.

Various embodiments disclosed herein are related to a memory device. In some embodiments, the memory device includes a word line coupled to a gate of a first memory cell and a gate of a second memory cell. In some embodiments, the memory device includes a first bit line coupled to the first memory cell. In some embodiments, the memory device includes a second bit line coupled to the second memory cell. In some embodiments, the memory device includes a first sense amplifier circuit coupled to the first bit line. The first sense amplifier circuit may include a first node. In some embodiments, the memory device includes a second sense amplifier circuit coupled to the second bit line. The second sense amplifier circuit may include a second node. In some embodiments, during a first period, the first sense amplifier circuit is configured to apply a first voltage to the first node. In some embodiments, during the first period, the second sense amplifier circuit is configured to apply the first voltage to the second node. In some embodiments, during a second period after the first period, the first sense amplifier circuit is configured to apply a second voltage to the first node, according to a potential of the first node changed from the first voltage applied being below a threshold voltage. In some embodiments, during the second period, the second sense amplifier circuit is configured to apply a third voltage higher than the second voltage to the second node, according to the potential of the second node changed from the first voltage applied being above the threshold voltage.

In some embodiments, the first sense amplifier circuit includes a first capacitor coupled to the first node. In some embodiments, the second sense amplifier circuit includes a second capacitor coupled to the second node.

In some embodiments, the first sense amplifier circuit includes a first transistor coupled to the first capacitor in series between the first node and a third node. In some embodiments, the second sense amplifier circuit includes a second transistor coupled to the second capacitor in series between the second node and the third node.

In some embodiments, during the second period, the second transistor is enabled, according to the potential of the second node changed from the first voltage applied being above the threshold voltage. The second transistor may be enabled during the second period to apply the third voltage to the second node.

In some embodiments, during the second period, the first transistor is disabled, according to the potential of the first node changed from the first voltage applied being below the threshold voltage. The first transistor may be disabled during the second period to apply the second voltage to the first node.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. The accompanying claims are intended to cover forms or modifications as would fall within the scope of the inventions.

## Claims

1. A memory device comprising:
a memory cell (MT);
a word line (WL) coupled to the memory cell;
a bit line (BL) coupled to the memory cell;
a first transistor (T15) having a gate coupled to a first node (SEN) coupled to the bit line (BL), the first transistor (T15) coupled to a second node (LBUS);
a first latch circuit (ADL) coupled to the second node (LBUS), the first latch circuit (ADL) including a third node (LATA);
a second transistor (T9, T32) coupled between the first node (SEN) and a fourth node (VHLB, CLKSA), a gate of the second transistor (T9, T32) coupled to a node (SPC) different from the third node (LATA); and
a third transistor (T2, T31) coupled between the first node (SEN) and the fourth node (VHLB, CLKSA), a gate of the third transistor (T2m T31) coupled to the third node (LATA).

2. The device according to claim 1, wherein the second transistor (T9, T32) and the third transistor (T2, T31) are coupled in parallel with each other between the first node (SEN) and the fourth node (VHLB, CLKSA).

3. The device according to claim 1 or 2, wherein the first latch circuit includes:
a first inverter circuit having an input coupled to the third node, and an output coupled to a fifth node; and
a second inverter circuit having an input coupled to the fifth node, and an output coupled to the third node.

4. The device according to any preceding claim, wherein the first node is (SEN) configured to receive a dynamically selected one of a first voltage or a second voltage higher than the first voltage.

5. The device according to any preceding claim, further comprising:
a fourth transistor (T14) coupled between the first transistor (T15) and the second node (LBUS).

6. The device according to any preceding claim, further comprising:
a fifth transistor (T10) coupled to the second transistor (T9) in series between the first node (SEN) and the fourth node (VHLB).

7. The device according to any preceding claim, further comprising:
a capacitor (P1) coupled to the first node (SEN).

8. The device according to any preceding claim, further comprising:
a second latch circuit (BDL) coupled to the second node (LBUS);
wherein, throughout a first period (t11-t29), a first voltage (VH) is applied to the word line (WL), wherein the first period (t11-t29) includes a second period (t14-t19), a third period (t20-t23) after the second period (t14-t19), and a fourth period (t23-t28) after the third period (t20-t23),
wherein, in the second period (t14-t19), the first latch circuit (ADL) is configured to store first data corresponding to the potential of the first node (SEN),
wherein, in the third period (t20-t23), either one of a second voltage (VSEN1', VSEN1, VSEN1') or a third voltage (VSEN2', VSEN4, VSEN5) higher than the second voltage (VSEN1', VSEN1, VSEN1') is applied to the first node (SEN), according to the first data, and
wherein, in the fourth period (t23-t28), the second latch circuit (BDL) is configured to store second data corresponding to the potential of the first node (SEN) changed from the one of the second voltage (VSEN1', VSEN1, VSEN1') or the third voltage (VSEN2', VSEN4, VSEN5) applied.

9. The device according to claim 8, wherein, in the third period (t20-t23), the second voltage (VSEN1', VSEN1, VSEN1') is applied to the first node (SEN), according to the first data being a first value.

10. The device according to claim 9, wherein, in the third period (t20-t23), the third voltage (VSEN2', VSEN4, VSEN5) is applied to the first node (SEN), according to the first data being a second value.

11. A memory device comprising:
a memory cell (MT);
a word line (WL) coupled to the memory cell;
a bit line (BL) coupled to the memory cell; and
a sense amplifier circuit (SAC) coupled to the bit line (BL), the sense amplifier circuit (SAC) including a first node (SEN), the sense amplifier circuit (SAC) configured to acquire data based on a potential of the first node (SEN),
wherein a first voltage (VH) is applied to the word line (WL) throughout a first period (t11-t29),
wherein the first period (t11-t29) includes a second period (t14-t19), a third period (t20-t23) after the second period (t14-t19), and a fourth period (t23-t28) after the third period (t20-t23), and
wherein the sense amplifier circuit (SAC) is configured to:
acquire first data based on the potential of the first node (SEN) in the second period (t14-t19),
apply either one of a second voltage (VSEN1', VSEN1, VSEN1') or a third voltage (VSEN2', VSEN4, VSEN5) higher than the second voltage (VSEN1', VSEN1, VSEN1') to the first node (SEN) in the third period (t20-t23), based on the first data, and
acquire second data in the fourth period (t23-t28), based on the potential of the first node (SEN) changed from the one of the second voltage (VSEN1', VSEN1, VSEN1') or the third voltage (VSEN2', VSEN4, VSEN5) applied.

12. The device according to claim 11, wherein the sense amplifier circuit (SAC) is configured to:
apply the second voltage (VSEN1', VSEN1, VSEN1') to the first node (SEN) prior to applying the third voltage (VSEN2', VSEN4, VSEN5) in the third period (t20-t23).

13. The device according to claim 11, wherein the sense amplifier circuit (SAC) is configured to:
apply, the second voltage (VSEN1', VSEN1, VSEN1') to the first node (SEN) in the third period (t20-t23), in response to the first data corresponding to the memory cell turned on during the second period (t14-t19), and
apply, the third voltage (VSEN2', VSEN4, VSEN5) to the first node in the third period (t20-t23), in response to the first data corresponding to the memory cell turned off during the second period (t14-t19).

14. The device according to claim 13, further comprising:
a first transistor (T5) coupled between the bit line (BL) and the first node (SEN),
wherein the first transistor (T5) is turned on throughout a fifth period (t14-t15) within the second period (t14-t19), and
wherein the first transistor (T5) is turned on throughout a sixth period (t23-t24) within the fourth period (t23-t28), the sixth period (t23-t24) longer than the fifth period (t14-t15).

15. The device according to claim 14, further comprising:
a second transistor (t15) having a gate coupled to the first node (SEN);
a first latch circuit (ADL) configured to store the first data; and
a third transistor (T14) coupled between the second transistor (T15) and the first latch circuit (ADL),
wherein the first period (t11-t29) further includes a seventh period (t16-t18) between the fifth period (t14-t15) and the third period (t20-t23), and an eighth period (t25-t27) after the sixth period (t23-t24),
wherein the third transistor (t14) is turned on in each of the seventh period (t16-t18) and the eighth period (t25-t27), and
wherein the third transistor (t14) is turned off in a time period (t18-t25) between the seventh period (t16-t18) and the eighth period (t25-t27).

16. A memory device comprising:
a word line (WL) coupled to a gate of a first memory cell (MT) and a gate of a second memory cell (MT);
a first bit line (BL) coupled to the first memory cell;
a second bit line (BL) coupled to the second memory cell;
a first sense amplifier circuit (SAC) coupled to the first bit line (BL), the first sense amplifier circuit (SAC) including a first node (SEN);
a second sense amplifier circuit (SAC) coupled to the second bit line (BL), the second sense amplifier circuit (SAC) including a second node (SEN);
wherein, during a first period (t12-t14), the first sense amplifier circuit (SAC) is configured to apply a first voltage (VSEN1') to the first node (SEN),
wherein, during the first period (t12-t14), the second sense amplifier circuit (SAC) is configured to apply the first voltage (VSEN1') to the second node (SEN),
wherein, during a second period (t20-t23) after the first period (t12-t24), the first sense amplifier circuit (SAC) is configured to apply a second voltage (VSEN1', VSEN1, VSEN1') to the first node (SEN), according to a potential of the first node (SEN) changed from the first voltage (VSEN1') applied being below a threshold voltage, and
wherein, during the second period (t20-t23), the second sense amplifier circuit (SAC) is configured to apply a third voltage (VSEN2', VSEN4, VSEN5) higher than the second voltage (VSEN1', VSEN1, VSEN1') to the second node (SEN), according to the potential of the second node (SEN) changed from the first voltage (VSEN1') applied being above the threshold voltage.

17. The device according to claim 16,
wherein the first sense amplifier circuit (SAC) includes a first capacitor (P1) coupled to the first node (SEN), and
wherein the second sense amplifier circuit (SAC) includes a second capacitor (P1) coupled to the second node (SEN) .

18. The device according to claim 17,
wherein the first sense amplifier circuit (SAC) includes a first transistor (T2, T31) coupled to the first capacitor (P1) in series between the first node (SEN) and a third node (VHLB, CLKSA), and
wherein the second sense amplifier circuit (SAC) includes a second transistor (T2, T31) coupled to the second capacitor (P1) in series between the second node (SEN) and the third node (VHLB, CLKSA).

19. The device according to claim 18,
wherein, during the second period (t20-t23), the second transistor (T2, T31) is enabled, according to the potential of the second node (SEN) changed from the first voltage (VSEN1') applied being above the threshold voltage, and
wherein the second transistor (T2, T31) is enabled during the second period (t20-t23) to apply the third voltage (VSEN2', VSEN4, VSEN5) to the second node (SEN).

20. The device according to claim 19,
wherein, during the second period (t20-t23), the first transistor (T2, T31) is disabled, according to the potential of the first node (SEN) changed from the first voltage (VSEN1') applied being below the threshold voltage, and
wherein the first transistor (T2, T31) is disabled during the second period (t20-t23) to apply the second voltage (VSEN1', VSEN1, VSEN1') to the first node (SEN).
